# EUROPÄISCHE PATENTSCHRIFT

(11) **EP 1 540 507 B1**
(45) Veröffentlichungstag und Bekanntmachung des Hinweises auf die Patenterteilung: **23.05.2012**
(21) Anmeldenummer: 02727358.0
(22) Anmeldetag: 05.03.2002
(51) Int. Cl.: G06F 15/78, G06F 9/45, H03K 19/177

(54) **VORRICHTUNG ZUR DATENVERARBEITUNG MIT EINEM FELD REKONFIGURIERBARER ELEMENTE**
DEVICE FOR PROCESSING DATA WITH AN ARRAY OF RECONFIGURABLE ELEMENTS
DISPOSITIF POUR TRAITER DES DONNÉES AVEC UN RÉSEAU D'ÉLEMENTS RECONFIGURABLES

(30) Priorität: 05.03.2001 DE 10110530; 07.03.2001 DE 10111014; 13.06.2001 WO PCT/EP01/06703; 20.06.2001 DE 10129237; 20.06.2001 EP 01115021; 24.07.2001 DE 10135210; 24.07.2001 DE 10135211; 24.07.2001 WO PCT/EP01/08534; 16.08.2001 DE 10139170; 29.08.2001 DE 10142231; 03.09.2001 DE 10142894; 03.09.2001 DE 10142903; 03.09.2001 DE 10142904; 07.09.2001 US 317876 P; 11.09.2001 DE 10144732; 11.09.2001 DE 10144733; 17.09.2001 DE 10145792; 17.09.2001 DE 10145795; 19.09.2001 DE 10146132; 28.09.2001 US 967847; 30.09.2001 WO PCT/EP01/11299; 08.10.2001 WO PCT/EP01/11593; 05.11.2001 DE 10154259; 05.11.2001 DE 10154260; 14.12.2001 EP 01129923; 18.01.2002 EP 02001331; 19.01.2002 DE 10202044; 20.01.2002 DE 10202175; 15.02.2002 DE 10206653; 18.02.2002 DE 10206856; 18.02.2002 DE 10206857; 21.02.2002 DE 10207225; 21.02.2002 DE 10207224; 21.02.2002 DE 10207226; 27.02.2002 DE 10208434; 27.02.2002 DE 10208435
(43) Veröffentlichungstag der Anmeldung: 15.06.2005
(73) Patentinhaber: Richter, Thomas, 04703 Bockelwitz (DE); Krass, Maren, 8044 Zürich (CH)
(72) Erfinder: VORBACH, Martin, 80689 München (DE)
(74) Vertreter: Pietruk, Claus Peter
(86) Internationale Anmeldenummer: PCT/EP2002/002398
(87) Internationale Veröffentlichungsnummer: WO 2002/071248

(56) Entgegenhaltungen:
- EP-A- 0 497 029
- EP-A- 0 628 917
- EP-A- 1 061 439
- WO-A-00/77652
- DE-A1- 19 654 595
- US-A- 5 193 202
- US-A- 5 600 597
- US-A- 5 844 422
- US-A- 6 020 760
- US-A- 6 023 742
- ZHANG H ET AL: "A 1-V heterogeneous reconfigurable DSP IC for wireless baseband digital signal processing" IEEE JOURNAL OF SOLID-STATE CIRCUITS, IEEE SERVICE CENTER, PISCATAWAY, NJ, US, Bd. 35, Nr. 11, November 2000 (2000-11), Seiten 1697-1704, XP002413277 ISSN: 0018-9200
- MARGOLUS N: "An FPGA architecture for DRAM-based systolic computations" FIELD-PROGRAMMABLE CUSTOM COMPUTING MACHINES, 1997. PROCEEDINGS., THE 5TH ANNUAL IEEE SYMPOSIUM ON NAPA VALLEY, CA, USA 16-18 APRIL 1997, LOS ALAMITOS, CA, USA,IEEE COMPUT. SOC, US, 16. April 1997 (1997-04-16), Seiten 2-11, XP010247462 ISBN: 0-8186-8159-4
- COMPTON K ET AL: "Configurable Computing: A Survey of Systems and Software" INTERNET CITATION, [Online] 1999, XP002315148 Gefunden im Internet: URL:http://www.comp.nus.edu.sg/~panyu/file s/SurveyReconfigurableComputing.pd>

## Beschreibung

Die vorliegende Erfindung betrifft das oberbegrifflich Beanspruchte. Damit befaßt sich die vorliegende Erfindung mit rekonfigurierbaren Bausteinen im Allgemeinen und hierbei insbesondere, jedoch nicht ausschließlich mit der Entkopplung der Datenverarbeitung innerhalb des rekonfigurierbaren Bausteines bzw. innerhalb von Teilen des rekonfigurierbaren Bausteines und Datenströmen, und zwar sowohl innerhalb des rekonfigurierbaren Bausteines als auch zu und von Peripherie, Massenspeichern, Hostprozessoren und dergleichen.

Einem rekonfigurierbaren Baustein (VPU) werden an den Eingängen und/oder Ausgängen Speicher zugeordnet, um eine Entkopplung der internen Datenverarbeitung und i.b. der Rekonfigurationszyklen von den externen Datenströmen (zu/von Peripherie, Speichern etc) zu erreichen.

Unter einer rekonfigurierbaren Architektur werden vorliegend Bausteine (VPU) mit konfigurierbarer Funktion und/oder Vernetzung verstanden, insbesondere integrierte Bausteine mit einer Mehrzahl von ein- oder mehrdimensional angeordneten arithmetischen und/oder logischen, und/oder analogen und/oder speichernden und/oder intern/extern vernetzenden Baugruppen, die direkt oder durch ein Bussystem miteinander verbunden sind.

Zur Gattung dieser Bausteine zählen insbesondere systolische Arrays, neuronale Netze, Mehrprozessor Systeme, Prozessoren mit mehreren Rechenwerken und/oder logischen Zellen und/oder kommunikativen/peripheren Zellen (IO), Vernetzungs- und Netzwerkbausteine wie z.B. Crossbaz-Schalter, ebenso, wie bekannte Bausteine der Gattung FPGA, DPGA, Chameleon, XPUTER, etc.. Hingewiesen wird insbesondere in diesem Zusammenhang auf die folgenden Schutzrechte und Anmeldungen desselben Anmelders: DE 44 16 881 C2, DE 197 81 412A1, DE 197 81 483A1, DE 196 54 846 A1, DE 196 54 593A1, DE 197 04 044 A1, DE 198 80 129 A1, DE 198 61 088 A1, DE 199 80 312 A1, PCT/DE 00/C1869, DE 100 36 627 A1, DE 100 28 397 A1, PCT/DE 00/01869, DE 100 36 627 A1, DE 100 28 397 A1, DE 101 10 530 A1, DE 101 11 014 A1, PCT/EP O0/10516, EP 01 102 674 A1, DE 196 51 075 A1, DE 196 54 846 A1, DE 196 54 593 A1, DE 197 04 728 A1, DE 198 07 872, DE 101 39 170.6, DE 199 26 538 A1, DE 101 42 904 A1, DE 101 10 530 A1, DE 102 02 044 A1, DE 102 06 857 A1, DE 101 35 210 A1, EP 02 001 331 A1, EP 01 129 923 A1 sowie die jeweiligen Parallelanmeldungen hierzu.

Die o.g. Architektur wird beispielhaft zur verdeutlichung herangezogen und im folgenden VPU genannt. Die Architektur besteht aus beliebigen arithmetischen logischen (auch Speicher) und/oder Speicherzellen und/oder Vernetzungszellen und/oder kommunikativen/peripheren (IO) Zellen (PAEs), die zu einer ein- oder nehrdimeosionalen Matrix (PA) angeordnet sein können, wobei die Matrix unterschiedliche beliebig ausgestaltete Zellen aufweisen kann, auch die Bussysteme werden dabei als Zellen verstanden. Der Matrix als ganzes oder Teilen davon zugeordnet ist eine Konfigurationseinheit (CT), die die Vernetzung und Funktion des PA beeinflußt.

Speichrezugriffsverfahren für rekonfigurierbere Bausteine, die nach einem DMA-Prinzip arbeiten sind aus DE 41 16 881 C2 bekannt, wobei eine oder mehrere DMAs dabei durch Konfiguration entstehen. In DE 196 54 595 A1 sind DMAs fest in die Interfaco-Baugruppen implementiert und können durch das PA oder die CT angesteuert werden.

Aus der EP 1061 439 A1 ist ein Computersystem mit einem ersten und einem zweiten Prozessor wie einem rekonfigurierbaren FPGA bekannt, wobei ein Burstcontroller auf vom ersten Prozessor vorgesehene Burst-Instruktionen Daten aus einem Spelcher liest und In einen Burstspeicher schreibt. Die Burstinstruktion wird vor Instruktionen für den zweiten Prozessor ausgegeben, um die Latenz zu verringern.

In DE 196 54 846 A1 ist das Beschreiben von internen Speichern durch externe Datenströme und das Wiederauslesen der Speicherdaten an externe Einheiten beschrieben. DE 199 26 538 A1 beschreibt erweiterte Speicherkonzepte entsprechend DE 196 54 846, um eine einfacher zu programmierende und leistungsfähigere Datenubertragung zu erreichen. In US 6, 347, 346 wird ein Speichersystem beschrieben, das in allen wesentlichen Punkten DE 196 54 846 A1 entspricht, wobei es einen expliziten Bus (global system port) zu einem globalen Speicher aufweist. Es beschreibt US6, 341, 318 ein Verfahren zum Entkoppeln von externen Datenströmen von der internen Datenverarbeitung derart, dass ein Double-Buffer Verfahren verwendet wird, wobei jeweils ein Buffer die externen Daten aufnimmt/ausliest, während ein anderer die internen Daten aufnimmt/ausliest: sobald die Buffer entsprechend ihrer Funktion voll/leer rind, werden die Buffer umgeschaltet, d.h. der vormals für die interne Daten zustandige Buffer leitet nunmehr seineDaten an die Peripherie bzw. (liest neue Daten von der Peripherie), und die vormals für die externen Daten zuständige leiten nunmehr ihre Daten an das PA (lesen neue Daten von dem PA). Die Double-Buffer sind derart in der Applikation verwendet, dass sie einen zusamcuenhangenden Datenbereich buffern.

Derartige Doppelpufferanordnungen haben massive Nachteile insbesondere im Datenstrombereich, d.h. beim sogenannten Datastreaming, in welchem große Mengen an sukzessive in ein Prozessorfeld oder dergleichen einströmenden Daten auf immer wieder gleiche Weise bearbeitet werden müssen.

Aufgabe der Erfindung ist es, Neues für die gewerbliche Nutzung bereitzustellen.

Die Lösung der Aufgabe wird unabgängig beansprucht.

Die vorliegend Gesolneßene Techniz erlaubt im Gegensatz zu dem vorbekannten, gerade im Kernbereich typischer Anwendungen von rekonfigurierbaren Prozessoren nachteiligen Stand der Technik eine wesentlich einfachere Kontrolle der Buffer bzw. zwischengeschalteten Speicher. Externe und interne Bussysteme können aufgrund der zwischengeschaiteten Speichermittel problemfrei mit unterschiedlichen Transfer- bzw. Übertragungsraten und/oder Taktfrequenzen betrieben werden, weil durch die Buffer Daten zwischengespeichert werden. Es werden im Vergleich zu schlechteren Lösungen aus dem Stand der Technik weniger Speichermittel, typisch nur halb so viele Buffer bzw. Datentransferschnittstellenspeichermittel benötigt, wobei sich die Hardwarekosten massiv reduzieren; Schätzungen der Hardwarekostenreduktion belaufen sich auf 25% bis 50%. Auch ist es einfacher, Adressen zu generieren und die Anordnung zu programmieren, da die Buffer für den Programmierer transparent sind. Die Hardware ist einfacher zu beschreiben und ist zu debuggen.

Ein Paging-Verfahren kann integriert werden, das verschiedene Datenbereiche insbesondere für verschiedene Konfigurationen buffert.

Es sei zunächst darauf hingewiesen, daß verschiedene Speichersysteme als Schnittstelle (Interface) zur IO bekannt sind. Verwiesen wird auf DE 44 16 881 C2, DE 196 54 595 A1, DE 199 26 538 A1. Weiterhin ist aus DE 196 54 846 A1 ein Verfahren bekannt, bei dem zunächst Daten von der IO geladen werden, (1) Daten nach deren Berechnung innerhalb einer VPU gespeichert werden, (2) das Array (PA) umkonfiguriert wird, (3) die Daten aus dem internen Speicher ausgelesen werden und wieder in einen anderen internen Speicher geschrieben werden, (4) so lange, bis das vollständig berechnete Ergebnis an die IO gesendet wird.Um- bzw. Rekonfiguration bedeutet, dass beispielsweise eine von einem Teil des Feldes rekonfigurierbarer Einheiten oder dem Gesamtfeld ausgeführte Funktion und/oder die Datenvernetzung und/oder Daten und/oder Konstanten, die bei der Datenverarbeitung erforderlich sind, neu bestimmte werden. Je nach Anwendung und/oder Ausgestaltung werden VPUs beispielsweise nur komplett oder auch partiell rekonfiguriert. Unterschiedliche Rekonfigurationsverfahren sind implemontierbar, z.B. komplette Rekonfiguration durch Umschalten von Speicherbereichen DE 196 51 075 A1, DE 196 54 846 A1 und/oder WaveReconfiguratioN (DE 198 07 872 A1, DE 199 26 538 A1, DE. 100 28 397 A1, DE 102 06 857 A1) und/oder einfaches konfigurieren adressierbarer Konfigurationsspeicher (DE 196 51 075 A1, DE 196 54 846 A1, DE 196 54 593 A1).

In einer bevorzugten Ausgestaltung ist eine VPU gesamt oder partiell mittels eine WaveRekonfiguration oder dem direkten Setzen von adressierbarer Konfigurationsspeicher konfigurierbar.

Es besteht somit eines der wesentlichen Arbeitsprinzipien der VPU-Bausteine darin, Daten zwischen mehreren Speichern hin und her zu kopieren, wobei während jedes Kopiervorganges zusätzliche und ggf. dieselben (z.B. langer FIR-Filter) und/oder andere (z.B. FFT gefolgt von Viterbi) Operationen über den Daten durchgeführt werden. Abhängig von der jeweiligen Applikation werden die Daten aus einem oder mehreren Speichern gelesen und in einen oder mehrere Speicher geschreiben.

Zum Speichern von Datenströmen und/oder Zuständen (Trigger, vgl. DE 197 04 728 A1, DE 199 26 538 (A1) werden interne/externe Speicher (z.B. als FIFOs) verwendet und entsprechende Adressgeneratoren eingesetzt. Jede sinnvolle Speicherarchitektur kann algorithmenspezifisch fest implementiert und/oder flexibel konfiguriert werden/sein.
Vorzugsweise werden aus Performancegründen die internen Speicher der VPU verwendet, grundsätzlich sind auch externe Speicher verwendbar.

Dies vorangestellt, sei nunmehr zum prinzipiellen Aufbau folgendes angemerkt:
Einem Array (PA) werden Interface-Baugruppen zugeordnet, die Daten zwischen den Bussystemen des PA und externen Einheiten kommunizieren (vgl. P 44 16 881 A1 DE 196 54 595 A1). Die Interface-Baugruppen verknüpfen Adressbusse und Datenbusse derart, dass eine feste Zuordnung zwischen Adressen und Daten entsteht. Bevorzugt können Interface-Baugruppen selbständig Adressen oder Teile von Adressen generieren.
Den Interface-Baugruppen werden FIFOs zugeordnet, die die interne Datenverarbeitung von der, externen Datenübertragung entkoppeln. Ein FIFO stellt hier ein datendurchströmbares Puffer- bzw. Eingangs-/Ausgangsdatenspeichermittel dar, das zur Datenverarbeitung insbesondere während des Ausführens ein und derselben Konfiguration nicht umgeschaltet werden muß. Soweit neben FIFO-Speichern andere datendurchströmbare Puffermittel bekannt sind, werden diese nachfolgend gleichfalls als von dem Begriff umfaßt sein, wo anwendbar. Erwähnt seien insbesondere Ringspeicher mit einem oder mehreren Zeigern, insbesondere wenigstens einem Schreib- und einem Lesespeicher. Somit kann beispielsweise während mehrerer Rekonfigurationszyklen zur Abarbeitung einer Applikation der externe Datenstrom weitgehend konstant aufrecht erhalten werden, unabhängig von den internen Verarbeitungszyklen. Die FIFOs können eingehende/ausgehende Daten und/oder Adressen speichern. Die FIFOs können in eine Interface-Baugruppe integriert oder dieser oder mehreren dieser zugeordnet werden. Es können je nach Ausgestaltung auch FIFOs in den' Interfacebaugruppen integriert sein und gleichzeitig zusätzliche separate implementiert sein. Auch sind datendurchströmbare Puffermittel möglich, die integriert mit dem Baustein sind, beispielsweise durch Integration von FIFO-Grupen auf einem eine rekonfigurierbare Prozessoranordnung bildenden Chip.

Zwischen den (auch separaten) FIFO's und den Interface-Baugruppen können in einer möglichen Ausgestaltung Multiplexer zur freien Zuordnung von Interface-Baugruppen und FIFOs vorhanden sein. Die von einem Multiplexer jeweils eingenommene Zuschaltung von FIFOs zu externen Baugruppen oder internen Teilen des Prozessorfeldes kann in einer bevorzugten Anordnung aus dem Prozessorfeld heraus vorgegeben werden, beispielsweise von der datensendenden und/oder -empfangenden PAE, ist aber auch, sollte dies gewünscht sein, von einer hierarchisch übergeordneten Einheit bestimmbar, wie einem Hostprozessor im Fall der Aufteilung der Datenverarbeitung in einen hochparallelen und einen schlecht parallelisierbaren Aufgabenanteil und/oder es ist möglich, die Multiplexer-Schaltung durch externe Vorgaben zu bestimmen, was sinnvoll sein kann, wenn mit den Daten etwa angegeben wird, um welche Art von Daten es sich handelt und wie sie zu verarbeiten sind.
Seitens des externen Anschlusses sind Einheiten zur Protokollkonvertierung zwischen den internen und den externen Busprotokollen (z.B. RAMBUS, AMBA, PCI, etc) vorgesehen. Mehrere unterschiedliche Protokollkonverter können innerhalb einer Ausgestaltung verwendet werden. Die Protokollkonverter können separat ausgestaltet sein oder in die FIFOs oder in die Interface-Baugruppen integriert sein.
Zwischen den (separaten) Protokollkonvertern und den Interface-Baugruppen/FIFOS können in einer möglichen Ausgestaltung Multiplexer zur freien Zuordnung von Interface-Baugruppen/FIFOs und Protokollkonvertern vorhanden sein.
Den Protokollkonvertern nachgeschaltet kann sich eine weitere Multiplexerstufe befinden, wodurch beispielsweise mehrere AM-BA-Businterface auf denselben AMBA-Bus aufgeschaltet sein können. Diese Multiplexerstufe kann beispielsweise auch durch die Eigenschaft eines externen Busses entstehen, mehrere Einheiten adressieren zu können.

In einer bevorzugten Ausführung arbeitet die Schaltung in einem Master und einem Slave Betriebsmodus. Im Mastermodus werden die Adressen und Buszugriffe durch die Schaltung und/oder das zugeordnete PA generiert, im Slavemodus wird von externen Einheiten auf die Schaltung bzw. das PA zugegriffen.

In weiteren Ausgestaltungen können innerhalb der Schaltung applikationsabhängig zusätzliche Pufferspeicher oder Datensammelspeicher (Collector) zum Datenaustausch zwischen den Interface-Baugruppen vorgesehen sein. Diese Pufferspeicher arbeiten bevorzugt in einem Random-Äccess- und/oder MMU-Paging- und/oder Stack-Modus und können eigene Adressgeneratoren aufweisen. Die Pufferspeicher sind bevorzugt als Multi-Port Speicher ausgestaltet, um den gleichzeitigen Zugriff mehrerer Interface-Bauguppen zu ermöglichen. Auf die Pufferspeicher kann von einer übergeordneten Datenverarbeitungseinheit insbesondere von dem rekonfigurierbaren Baustein (VPU) zugeordneten Prozessoren wie DSPs, CPUs, Mikrokontroller etc. zugegriffen werden.

Es sei nun angegeben, wie auf besondere Weise externe Datenströme entkoppelt werden können. Gemäß einem wesentlichen Aspekt der Erfindung werden die externen Datenströme durch FIFOs (Input-/output-FIFO, zusammengefaßt IO-FIFO), die zwischen der Protokollkonvertern und den Interface-Baugruppen eingesetzt sind, entkoppelt.
Das Datenverarbeitungsverfahren funktioniert wie folgt: Durch einen oder mehrere Input-FIFO werden die eingehenden Daten von der Datenverarbeitung im Array (PA), entkoppelt. Die Datenverarbeitung kann in folgenden Schritten erfolgen:
1. Das/die Input-FIFO wird/werden ausgelesen, vom Array (PA) verarbeitet und/oder in einen oder mehrere (andere), lokal dem Array zugeordneten und/oder bevorzugt seitliche an das Array gekoppelten Speicher (RAM-Bankl) geschrieben. Die seitliche Ankopplung hat den Vorteil, daß sich die Chiparchitektur und/oder deren Entwurf vereinfacht.
2. Das Array (PA) wird umkonfiguriert. Die Speicher (z.B. RAM-Bankl) werden ausgelesen, die Daten werden verarbeitet und in einen oder mehrere Speicher (z.B. RAM-Bank2 und/oder RAM-Bankl) oder alternativ bereits an die Output-FIFOs gemäß Schritt 4 geschrieben.
3. Das Array (PA) wird wieder umkonfiguriert und die Daten werden wieder in ein Speicher geschrieben.
4. Dies setzt sich so lange fort, bis das Ergebnis an einen oder mehrere Output-FIFO zum Ausgang gesendet wird.
5. Danach werden wieder neue Daten von dem/den Input-FIFO ausgelesen und entsprechend verarbeitet, d.h. die Datenverabeitung wird bei Schritt 1 fortgesetzt.

Durch die bevorzugte Ausbildung der Input-/Output-FIFOs (IO-FIFOs) als multi-ported FIFOs kann die Datenverarbeitung dabei zeitgleich mit dem Einschreiben bzw. Auslesen der jeweiligen FIFOs durch die Protokollkonverter erfolgen. Durch die vorstehend beschriebenen Weise entsteht eine zeitliche Entkopplung, die die "quasistationäre" Verarbeitung von konstanten Datenströmen derart ermöglicht, daß lediglich noch eine Latenz, aber keine Unterbrechung des Datenstromes mehr auftritt, wenn die ersten Datenpakete durchgelaufen sind.
In einer erweiterten Ausgestaltung können die IO-FIFOs derart aufgebaut sein, das entsprechend der Applikation die Anzahl der IO-FIFOs und deren Tiefe gewählt werden kann. Mit anderen Worten können IO-FIFOs (z.b. über Transmission Gate, Multiplexer/Demultioplexer etc) zerteilt oder zusammengefaßt werden, sodass mehr oder tiefere IO-FIFOs entstehen. Beispielsweise können 8 FIFOs zu je 1024 Worten implementiert sein, die derart konfiguriert werden, dass entweder 8 FIFOs á 1024 Worte oder 2 FIFOs á 4096 Worte oder z.B. 1 FIFO mit 4096 Worten und 4 mit 1024 Worten konfiguriert sind.

Je nach Ausgestaltung des Systems und Anforderungen der Algorithmen sind Modifikationen des beschriebenen Datenverarbeitungsverfahrens möglich.
In einer erweiterten Ausgestaltung arbeiten die FIFOs derart, dass bei Output-FIFOs auch die zu den Dateneinträgen gehörenden Adressen in den FIFOs gespeichert werden und/oder Input-FIFOs derart aufgebaut sind, dass jeweils ein FIFO für die auszusendende/ausgesendete Leseadressen und ein FIFO für die eingehenden den Adressen zugeordneten Datenworte existiert.

### Es sei nun diskutiert, wie eine mögliche FI-FO-RAM-Bank Kopplung in einer besonders bevorzugten Variante erfolgen kann.

Je nach Applikation ist es möglich, den Datentransfer mit den IO-FIFOs über'eine oder mehrere weitere, lokal dem Array zugeordnete oder bevorzugt seitlich an das Array gekoppelte, speicherstufe(n) (RAM-Bank) zu führen und erst dann an die datenverarbeitenden PAEs (z.B. ALU-PAEs nach DE 196 51 0.75 A1) weiterzuleiten.
In einer bevorzugten Ausgestaltung weisen RAM-PAEs mehrere Daten- und Adressinterfaces auf, sind also als multiport-Anordnungen ausgebildet. Die Ausgestaltbarkeit eines Daten- und/oder Adressinterfaces als globalen Systemport sei als möglich erwähnt.

Die zusätzliche Speicherstufe(n) (RAM-Bank) können beispielsweise durch speicherbaugruppen entsprechend den RAM-PAEs nach DE 196 54 846 A1 und/oder DE 199 26 538 A1 und/oder PCT/EP 00/10516 realisiert sein.
Mit anderen Worten kann eine RAM-PAE einen passiven (im wesentlichen) auf die Speicherfunktion beschränkten Speicher (siehe DE 196 54 846 A1) oder aber einen aktiven Speicher, der Funktionen wie z.B. Adressberechnung und/oder Buszugriffe selbständig generiert und steuert (siehe DE 199 26 538 A1) darstellen. Insbesondere können in einer möglichen Ausgestaltung auch aktive Adressgenerierungsfunktionen und/oder Datentransferfunktionen für einen 'global system port' implementiert sein. Aktive Speicher können je nach Ausgestaltung einen oder mehrere Daten- und Adressinterface aktiv (aktive Interface) verwalten. Aktive Interface können beispielsweise durch zusätzliche Baugruppen wie beispielsweise Sequenzer/Zustandsmaschinen und/oder ALUs und/oder Register, etc., innerhalb einer RAM-PAE realisiert sein und/oder durch die geeignete Verschaltung eines aktiven Interfaces mit anderen PAEs erfolgen, deren Funktion und Vernetzung entsprechend der zu realisierenden Funktionen in einer oder mehrerer RAM-PAEs konfiguriert. Unterschiedlichen RAM-PAEs können unterschiedliche andere PAEs zugeordnet werden.

RAM-PAEs weisen bevorzugt eine oder mehrere der folgenden Funktionen bzw. Betriebsarten auf: random access, FIFO, Stack, Cache, MMU-paging. RAM-PAEs sind in einer bevorzugten Ausgestaltung über einen Bus mit einer Übergeordneten Konfiguratioriseinheit (CT) verbunden und können durch diese in ihrer Funktion und/oder Vernetzung und/oder Speichertiefe und/oder Betriebsart konfiguriert werden. Weiterhin besteht bevorzugt die Möglichkeit, Speicherinhalte durch die CT vorzuladen und auszulesen, z.B. um Konstante und/oder Lookup-Tabellen (cos/sin) zu setzen.

Durch die Verwendung von multi-ported Speichern für die RAM-PAEs kann das Einschreiben bzw. Auslesen von Daten von/zu den IO-FIFOs und der Datenzugriff durch das Array (PA) zeitgleich erfolgen, sodass die RAM-PAEs ihrerseits wiederum eine Puffer-Eigenschaft aufweisen können, wie beispielsweise in DE 196 54 846.2 aufgezeigt.

RAM-PAEs können, wie beispielsweise in PCT/EP 00/10516 dargestellt, derart zusammengefasst werden, dass grössere Speicherblöcke entstehen bzw. dass die RAM-PAEs derart arbeiten, dass die Funktion eines größeren speichers entsteht (z.B. aus 2 512 Wort RAM-PAEs ein 1024 Wort RAM-PAE).

In einer möglichen Ausführung kann die Zusammenfassung derart erfolgen, dass an mehrere Speicher dieselbe Adresse geführt wird. Die Adresse wird derart unterteilt, dass ein Teil die Einträge in den Speichern adressiert und ein anderer Teil die Nummer des selektierte Speichers (SEL) angibt. Jeder Speicher besitzt eine eindeutige Nummer und kann durch einen Vergleich derer mit SEL eindeutig selektiert werden kann. In einer bevorzugten Ausführung ist die Nummer für jeden Speicher konfigurierbar.

In einer weiteren und/oder zusätzlichen möglichen Ausführung wird eine Adresse von einem Speicher zum Nächsten weitergeleitet wird. Die Adresse wird derart unterteilt, dass ein Teil die Einträge in den Speichern adressiert und ein anderen Teil die Nummer (SEL) des selektierten Speichers angibt. Diese wird bei jeder Weiterleitung modifiziert, beispielsweise kann dieser bei jeder Weiterleitung eine 1 subtrahiert werden. Der Speicher bei dem dieser Adressteil einen bestimmten Wert aufweist (z.B. Null), wird aktiviert.

In einer möglichen Ausführung kann die Zusammenfassung derart erfolgen, dass an mehrere Speicher dieselbe Adresse geführt wird. Die Adresse wird derart unterteilt, dass ein Teil die Einträge in den Speichern adressiert und ein anderer Teil die Nummer (SEL) des selektierten Speichers angibt. Zwischen den Speichern verläuft ein Bus von jeweils einem Speicher zum Nächsten, der eine Referenzadresse derart aufweist, dass diese bei dem ersten Speicher einen bestimmten Wert aufweist (z.B. null) und dieser bei jeder Weiterleitung modifiziert wird (z.B. wird eine 1 aufaddiert). Dadurch besitzt jeder Speicher eine andere eindeutige Referenzadresse. Der Teil der Adresse, die die Nummer des selektierten Speichers aufweist, wird jeweils mit der Referenzadresse verglichen. Bei Gleichheit ist der betreffende Speicher selektiert. Je nach Ausgestaltung kann der Referenzbus über das gewöhnliche Datenbussystem oder über einen separierten Bus aufgebaut sein.

In einer möglichen Ausführung kann jeweils eine Bereichsüberprüfung des Adressteils SEL erfolgen, um Fehladressierungen auszuschließen.

Es sei nun darauf hingewiesen, daß es möglich ist, die RAM-PAEs als FIFOs zu benutzen. Dies kann besonders bevorzugt sein, wenn eine vergleichsweise große Speicherkapazität durch RAM-PAEs vorgesehen wird.. Es entsteht somit besonders unter Ausnutzung von multi-ported Speichern für die RAM-PAEs die Ausgestaltungsmöglichkeit, auf explizite IO-FIFOs zu verzichten und/oder zusätzlich zu den IO-FIFOs eine entsprechende Anzahl PAE-RAMs als FIFO zu konfigurieren und die Daten der IO an die entsprechenden Ports der Speicher zu führen. Diese Ausgestaltung kann als besonders kosteneffizient angesehen werden, da keinerlei zusätzlichen Speicher vorgesehen werden müssen, sondern die in ihrer Funktion und/oder Vernetzung konfigurierbaren Speicher der VPU Architektur (vgl. DE 196 54 846A1, DE 199 26 538A1, PCT/EP 00/10516) entsprechend des Charakters konfigurierbarer Prozessoren konfiguriert werden.

Es ist weiter möglich, einen Multiplexer/Demultiplexer vor und/oder nach dem FIFO vorzusehen. Eingehende bzw. ausgehende Datenströme können aus einem Datensatz oder mehreren Datensätzen entstehen. Beispielsweise benötigt die Funktion

```
 function example (a, b : integer) -> x : integer
 for i:= 1 to 100
   for j := 1 to 100
     x[i] :- a[i] * b[j]
```

zwei eingehende Datenströmen (a und b) und einen ausgehenden Datenstrom (x).

Die Anforderung kann z.B. durch zwei Ansätze erfüllt werden:
a) Es werden exakt so viele IC-Kanäle implementiert, wie Datenströme erforderlich sind (vgl. DE 44 16 881C2, DE 196 54 595A); in der beispielsweise angegebenen Funktion wären also bereits drei I/O-Kanäle erforderlich; oder
b) Durch die Verwendung von internen Speichern zur Entkopplung der Datenströmen, quasi als Registersatz (vgl. DE 199 26 538A1, DE 196 54 846A1). Die unterschiedlichen Datenströme werden z.B. durch ein Zeitmultiplexverfahren zwischen einem oder mehrere Speichern und der 10 (z.B. Speicher, Peripherie, etc) ausgetauscht. Intern können die Daten dann ggf. parallel mit mehreren Speicher ausgetauscht werden,_sofern die IO-Daten beim Transfer zwischen diesen Speichern und der IO entsprechend sortiert (gesplittet) werden.

Der Ansatz a) wird erfindungsgemäß dadurch unterstützt, dass eine ausreichende Anzahl von IO-Kanälen und IO-FIFOs zur Verfügung gestellt wird. Allerdings ist dieser einfache Ansatz unbefriedigend, da eine nicht exakt bestimmbare, algorithmenabhänge und zudem sehr kostenaufwendige Anzahl von IO-Kanälen zur Verfügung gestellt werden muß.

Daher ist der Ansatz b) oder eine geeignete Mischung aus a) und b) vorzuziehen, z.B. 2 IO-Kanäle, ein Input und ein Output, wobei auf jedem Kanal die Datenströme ggf. gemultiplext werden. Es sei darauf hingewiesen, daß einleuchtenderweise die Schnittstellen in der Lage sein müssen, die Datenströme zu bearbeiten, also eine hinreichend hohe Taktfrequenz und/oder hinreichend niedrige Latenzzeiten auf den internen bzw. externen Bussen vorgesehen werden müssen. Dies kann der Grund sein, warum eine Mischung beider Varianten besonders bevorzugt ist, weil durch Vorsehen mehrerer paralleler I/O-Kanäle die erforderliche Taktung der externen und/oder internen Busse entsprechend herabsetzbar ist.

Für Ansatz b) bzw. Ansätze, in denen zumindest partiell auf Ansatz b) zurückgegriffen wird, ist es erforderlich Multiplexer bzw. Demultiplexer vorzusehen und die Datenströme von einem Datenkanal aufzutrennen (z.B. aus dem Input-Kanal muß a und b abgetrennt werden) oder mehrere Ergebniskanäle auf einen Output-Kanal zusammenzuführen.

Hierzu können ein oder mehrere Multiplexer/Demultiplexer (MuxDemux-Stufe) an verschiedenen Positionen angeordnet werden, abhängig von der hardwaretechnischen Realisierung bzw. den auszuführenden Funktionen. Zum Beispiel kann
a) eine MuxDemux-Stufe zwischen Input-/Output-Interface (z.B. nach DE 196 54 595A1) und der FIFO-Stufe (IO-FIFO und/oder PAE-RAM als FIFO)
b) eine MuxDemux-Stufe nach der FIFO-Stufe (IO-FIFO und/oder PAE-RAM als FIFO), also zwischen FIFO-Stufe und PA
c) eine MuxDemux-Stufe zwischen IO-FIFO und RAM-PAEs geschaltet werden.

Die MuxDemux-Stufe kann ihrerseits entweder in Hardware fest implementiert werden und/oder durch die geeignete Konfiguration von beliebigen entsprechend ausgebildeten PAEs entstehen.
Die Stellung der Multiplexer/Demultiplexer der MuxDemux-Stufe wird von der Konfiguration durch eine CT und/oder dem Array (PA) und/oder der IO selbst vorgegeben, wobei diese auch dynamisch, z.B. anhand des Füllgrades des/der FIFOs und/oder anhand anstehender Datentransfers (Arbitrierung) beeinflußt werden kann.

In einer bevorzugten Ausgestaltung wird die Multiplexer/Demultiplexer Struktur durch ein konfigurierbares Bussystem ausgebildet (z.B. entsprechend oder ähnlich dem Bussystems zwischen den (RAM/ALU/etc-PAEs), wobei das Bussystem insbesondere auch physikalisch dasselbe sein kann, das entweder durch Ressourcen-Sharing oder ein ZeitmultiplexVerfahren, das durch geeignete Rekonfiguration realisiert werden kann, mitbenutzt wird.

Besonders bevorzugt ist es, wenn Adressen auf eine besondere Art und Weise generiert werden, wie sich diese aus dem Nachfolgenden verschließt. Adressen für interne oder externe Speicher können durch Adressgeneratoren berechnet werden. Beispielsweise können Gruppen von PAEs entsprechend konfiguriert werden und/oder explizite und ggf. gesondert und speziell implementierte Adressgeneratoren (z.B. DMA wie aus DE 44 16 881 A1 bekannt oder innerhalb von Interface-Zellen (wie aus DE 196 54 595 A1 bekannt) eingesetzt werden. Mit anderen Worten können entweder fest implementierte Adressgeneratoren die in einer VPU integriert sind oder extern realisiert sind, verwendet werden, und/oder die Adressen durch eine Konfiguration von PAEs entsprechend den Anforderungen eines Algorithmus berechnet werden.

Vorzugsweise können einfache Adressgeneratoren fest in den Interface-Baugruppen und/oder aktiven Speicher (z.B. RAM-PAEs) implementiert sein. Zur Generierung komplexer Adressequenzen (z.b. nicht linear, multidimensional etc) können PAEs entsprechend konfiguriert und mit den Interface-Zellen verbunden werden. Derartige Verfahren mit den entsprechenden Konfigurationen sind aus PCT/EP 00/10516 bekannt.

Konfigurierte Adressgeneratoren können, einer anderen Konfiguration (Config-ID, vgl. DE 198 07 872A1, DE 199 26 538A1, DE 100 28 397A1) als die Datenverarbeitung angehören. Damit ist eine Entkopplung der Adressgenerierung von der Datenverarbeitung möglich, womit in einem bevorzugten Arbeitsverfahren beispielsweise Adressen bereits generiert und die entsprechenden Daten bereits geladen werden können, bevor oder während die datenverarbeitenden Konfiguration konfiguriert wird. Daß ein solches Datenvorladen bzw. Adressvorgenerieren zur Erhöhung der Prozessorleistung, insbesondere durch Latenzzeit- und/oder Wartetaktzyklusverringerung besonders bevorzugt ist, sei erwähnt. Entsprechend können Ergebnisdaten und deren Adressen noch bearbeitet werden, während oder nachdem die datenverarbeitende/-generierende Konfiguration entfernt wird. Insbesondere ist es möglich, durch den Einsatz von Speichern und/oder Puffern wie z.B. die beschriebenen FIFOs die Datenverarbeitung weiter von den Speicher- und/oder IO-Zugriffen zu entkoppeln.

Besonders leistungsfähig ist in einer bevorzugten Arbeitsweise eine Zusammenschaltung von fest implementierten Adressgeneratoren (HARD-AG) (DE 196 54 595A1) und konfigurierbaren Adressgeneratoren im PA (SOFT-AG) derart, dass für die Realisierung einfacher Adressierungsschematas die HARD-AG verwendet werden und komplizierte Adressierungsabläufe durch die SOFT-AG berechnet und dann an die HARD-AG geleitet werden. Mit anderen Worten können die einzelnen Adressgeneratoren sich gegenseitig überladen und neu setzen.

Interface-Baugruppen für rekonfigurierbare Bausteine werden bereits DE 196 54 595A1 offenbart. Es wurde gefunden, daß die dort offenbarten Interface-Baugruppen und deren Betrieb noch zur Erhöhung der Prozessoreffizienz und/oder Leistung verbesserbar sind. Es wird daher nachfolgend im Rahmen der Erfindung eine besondere Ausgestaltung von Interface-Baugruppen vorgeschlagen, wie sie insbesondere in DE 196 54 595A1 offenbart sind. Jedes Interface-Baugruppen kann eine eigene eindeutige Kennung (IOID) besitzen, die von/zu einem Protokollkonverter übertragen wird und der Zuordnung von Datentransfers zu einer bestimmten Interface-Baugruppe oder der Adressierung einer bestimmten Interface-Baugruppe dient. Die IOID kann bevorzugt durch eine CT konfigurierbar sein. Die IOID kann beispielsweise verwendet werden, um bei Zugriffen durch einen externen Master eine bestimmte Interface-Baugruppe für einen Datentransfer zu selektieren. Weiterhin kann die IOID verwendet werden um eingehenden Lesedaten die korrekte Interface-Baugruppe zuzuordnen. Dazu wird die IOID beispielsweise mit der Adresse eines Datenlesezugriffes in die IO-FIFOs übertragen und entweder dort gespeichert und/oder an den externen Bus weitergeleitet. Die IO-FIFOs ordnen den eingehenden Lesedaten die IOIDs der ausgesendeten Adressen zu und/oder die IOIDs werden über den externen Bus mitübertragen und durch externe Geräte oder Speicher den zurückgesendeten Lesedaten zugeordnet. IOIDs können dann die Multiplexer (z.B. vor den Interface-Baugruppen) derart ansprechen, dass diese die eingehenden Lesedaten auf die korrekte Interface-Baugruppe leiten.

Für gewöhnlich arbeiten Interface-Baugruppen und/oder Protokollkonverter als Busmaster. In einer besonderen Ausführung wird nun vorgeschlagen, daß Interface-Baugruppen und/oder Protokollkonverter alternativ und/oder fest und/oder temporär als Busslave arbeiten, insbesondere auf selektierbare Weise, beispielsweise im Ansprechen auf bestimmte Ereignisse, Zuständen von Statemachines in PAEs, Anforderungen einer zentralen Konfigurationsverwaltungseinheit (CT) usw. In einer zusätzlichen Ausführung sind die Interface-Baugruppen derart erweitert, dass generierten Adressen, i.b. in SOFT-AG generierten Adressen, ein bestimmtes Datenpaket zugeordnet wird.

Eine bevorzugte Ausgestaltung einer Interface-Baugruppe ist nachfolgend beschrieben:
Eine bevorzugte Kopplung eine Interface-Baugruppe erfolgt dadurch, dass beliebige PAEs (RAM, ALU, etc) und/oder das Array (PA) über einen (bevorzugt konfigurierbaren) Bus mit Interface-Baugruppen verbunden sind, welche entweder mit den Protokollkonvertern verbunden sind oder die Protokollkonverter integriert haben.
In einer Ausgestaltungvariante sind IO-FIFOs in den Interface-Baugruppen intergriert.

Für Schreibzugriffe (die VPU sendet Daten an externe IO, z.B. Speicher/Peripherie o.ä.) ist es vorteilhaft, den Adressoutput mit dem Datenoutput zu verknüpfen, d.h. ein Datentransfer mit der IO findet exakt dann statt, wenn an der Interface-Baugruppe ein gültiges Adresswort und ein gültiges Datenwort ansteht, wobei die beiden Worte von unterschiedlichen Quellen stammen können. Zur Kennzeichnung der Gültigkeit kann beispielsweise ein Handshake-Protokoll nach DE 196 51 075.9 oder DE 101 10 530.4 (RDY/ACK) verwendet werden. Durch eine geeignete logische Verknüpfung (z.B. 'AND') der RDY Signale von Adresswort und Datenwort ist das Vorhandensein beider gültiger Worte erkennbar und der IO-Zugriff kann durchgeführt werden. Mit der Durchführung des IO-Zugriffes kann die Quittierung der Daten- und Adressworte erfolgen, indem das entsprechende ACK für die beiden Transfers generiert wird. Der IO-Zugriff bestehend aus Adresse und Daten, sowie ggf. der dazugehörenden Statussignale kann erfindungsgemäß in Output-FIFOs entkoppelt werden. Bussteuersignale werden vorzugsweise in den Protokollkonvertern generiert.

Für Lesezugriffe (die VPU empfängt Daten von externer IO, z.B. Speicher/Peripherie o.ä.) werden zunächst die Adressen für den Zugriff von einem Adressgenerator (HARD-AG und/oder SOFT-AG) generiert und der Adresstransfer durchgeführt. Die Lesedaten können im selben Takt oder bei hohen Frequenzen auch gepipelinet einen oder mehrere Takte später eintreffen. Sowohl die Adressen als auch die Daten können durch IO-FIFOs entkoppelt werden. Zur Quittierung der Daten kann das bekannte RDY/ACK Protokoll verwendet werden, das auch gepipelinet verwendet werden kann (siehe DE 196 54 595A1, DE 197 04 742A1, DE 199 26 538A1, DE 100 28 397A1, DE 101 10 530A1). Zur Quittierung der Adressen kann ebenfalls das bekannte RDY/ACK Protokoll verwendet werden. Eine Quittierung der Adresse durch den Empfänger bewirkt jedoch eine sehr große Latenzzeit, die sich negativ auf die Performance von VPUs auswirken kann. Die Latenzzeit kann umgangen werden, indem die Interface-Baugruppe den Empfang der Adresse quittiert und die Synchronisation des Eingangs der der Adresse zugeordneten Daten mit dem Adresse übernimmt.

Die Quittierung und Synchronisation kann durch eine beliebige geeignete Quittierungs-Schaltung erfolgen. Zwei mögliche Ausgestaltungen seien im Folgenden nicht-limitierend näher ausgeführt:
a) FIFO Ein FIFO speichert die ausgehenden Adresszyklen der externen Bustransfers. Mit jedem als Antwort auf einen externen Buszugriff eingehenden Datenwort wird der FIFO entsprechend gelehrt. Durch den FIFO-Character entspricht die Reihenfolge der ausgehenden Adressen der Reihenfolge der ausgehenden Datenworte. Die Tiefe des FIFOs (also die Zahl der möglichen Einträge) wird vorzugsweise an die Latenzzeit des externen Systems angepaßt, sodass jede ausgehende Adresse ohne Latenz quittiert werden kann und der optimale Datendurchsatz erreicht wird. Eingehende Datenworte werden entsprechend des FIFO-Eintrages der zugeordneten Adresse quittiert. Wenn der FIFO voll ist, kann das externe System keine weiteren Adressen mehr annehmen und die aktuelle ausgehende Adresse wird so lange nicht quittiert und damit gehalten, bis Datenworte eines vorhergehenden Bustransfers eingegangen sind und ein FI-FO-Eintrag entfernt wurde. Ist der FIFO leer, wird kein gültiger Bustransfer ausgeführt und ggf. eintreffende Datenworte werden nicht quittiert.
b) Creditcounter Jede ausgehende Adresse von externen Bustransfers wird quittiert und zu einem Zähler dazuaddiert (Creditcounter). Eingehende Datenworte als Antwort auf einen externen Bustransfer werden werden von dem Zähler abgezogen. Erreicht der Zähler einen definierten Höchstwert, kann das externe System keine weiteren Adressen mehr annahmen und die aktuelle ausgehende Adresse wird so lange nicht quittiert und damit gehalten, bis Datenworte eines vorhergehenden Bustransfers eingegangen sind und der Zähler dekrementiert wurde. Ist der Zählerstand null, wird kein gültiger Bustransfer ausgeführt und ggf. eintreffende Datenworte werden nicht quittiert. Um Bursttransfers optimal zu unterstützen wird die Lösung mittels a) (FIFO) besonders bevorzugt, insbesondere können FIFOs ähnlich den nachfolgend beschriebenen FIFOs zur Abwicklung von Burstzugriffen und der Zuordnung von IOIDs zu den Lesedaten eingesetzt werden.

In die Interface-Baugruppen können die beschriebenen IO-FIFOs integriert sein. Insbesondere kann für die Ausgestaltungsvariante a) auch ein IO-FIFO verwendet werden.

Es wurde vorstehend schon die optionale Möglichkeit offenbart, Protokollkonverter vorzusehen. Zu besonders vorteilhaften möglichen Ausgestaltungen von Protokollkonvertern sei das Nachfolgende angemerkt:
Ein Protokollkonverter ist für die Verwaltung und Steuerung eines externen Busses zuständig. Detailaufbau und -funktion eines Protokollkonverter sind von der Ausgestaltung des externen Busses abhängig. Beispielsweise erfordert ein AMBA Bus einen anderen Protokollkonverter als ein RAMBUS. Unterschiedliche Protokollkonverter sind an die Interface-Baugruppen anschließbar, innerhalb einer Ausgestaltung einer VPU können mehrere und insbesondere unterschiedliche Protokollkonverter implementiert sein.
In einer bevorzugten Ausgestaltung sind die Protokollkonverter in den IO FIFOs der vorliegenden Erfindung integriert.

Es ist erfindungsgemäß möglich, Burst-Buszugriffe vorzusehen. Moderne Bussystem und SoC-Bussysteme transferieren große Datenmengen mittels sogenannter Burst-Sequenzen. Dabei wird zunächst eine Adresse übertragen und dann für eine Anzahl von Takten ausschließlich Daten transferiert (siehe AMBA Specification 2.0, ARM Limited).

Zur korrekten Durchführung von Burst-Zugriffen sind mehrere Aufgaben zu lösen:
1) Erkennen von Burstzyklen
   Lineare Buszugriffe, die in Bursts umgewandelt werden können, müssen erkannt werden, um Bursttransfers auf dem externen Bus auszulösen. Zur Erkennung linearer Adressfolgen kann ein Zähler (TCOUNTER) eingesetzt werden, der zunächst mit einer ersten Adresse eines ersten Zugriffes geladen wird und nach jedem Zugriff linear auf/ab zählt. Sofern die darauffolgende Adressen dem Zählerstand entspricht liegt eine lineare und burstfähige Reihenfolge vor.
2) Abbruch an Boundaries Manche Bussysteme (z.B. AMBA) lassen Bursts (a) nur bis zu einer bestimmten Länge, bzw. (b) nur bis zu bestimmten Adressgrenzen (z.B. 1024 Adress Blöcke) zu. Für (a) kann dann erfindungsgemäß ein einfacher Zähler implementiert werden, der vom ersten gewünschten bzw. erforderlichen Buszugriff an die Anzahl der Datenübertragungen zählt und bei einem bestimmten Wert, der der maximalen Länge des Bursttransfers entspricht, z.B. mittels eines Vergleichers die Boundarygrenze signalisiert. Für (b) kann das entsprechende Bit (z.B. für 1024 Adress Grenzen das 10.bit), das die Boundarygrenze darstellt, zwischen TCOUNTER und der aktuellen Adresse verglichen werden (z.B. mittels einer XOR Funktion). Ist das Bit in TCOUNTER ungleich dem Bit in der aktuellen Adresse lag ein Übergang über eine Boundarygrenze vor, der entsprechend signalisiert wird.
3) Festlegen der Länge Sofern das externe Bussystem keine Angabe zur Länge eines Burstzyklus benötigt, ist es möglich und erfindungsgemäß bevorzugt, Bursttransfers unbestimmter Länge durchzuführen (vgl. AMBA). Werden Längenangaben erwartet und/oder bestimmte Burstlängen vorgegeben, kann erfindungsgemäß folgendermaßen vorgegangen werden: Die zu übertragenden Daten und Adressen werden in ein FIFO bevorzugt unter Mitverwendung des IO-FIFOs dafür, geschrieben und sind anhand der Anzahl der Adressen im (IO-)FIFO bekannt. Für die Adressen wird ein Adress-FIFO verwendet, das im Mastermodus die Adressen von den Interface-Baugruppen zum externen Bus überträgt und/oder im Slavemodus umgekehrt arbeitet. Die Daten werden in ein Daten-FIFO geschrieben, das die Daten entsprechend der Übertragung (Schreiben/Lesen) überträgt. Insbesondere kann für Schreib und Lesetransfers je ein unterschiedliches FIFO verwendet werden. Die Bustransfers können nunmehr derart in fixe Burstlängen unterteilt werden, dass diese vor den einzelnen Bursttransfers bekannt sind und bei der Einleitung der Burst angegeben werden können, wobei vorzugsweise zunächst Bustransfers der maximalen Burstlänge gebildet werden und wenn die Anzahl der verbleibenden (IO-)FIFO-Einträge kleiner als die aktuelle Burstlänge ist jeweils eine nächst kleinere Burstlänge verwendet wird. Beispielsweise können 10 (IO-)FIFO-Eintrage bei einer maximalen Burstlänge von 4 mit 4,4,2 Bursttransfers übertragen werden.
4) Error Recovery Manche externen Bussysteme (vgl. AMBA) sehen Verfahren zur Fehlerbeseitigung vor, wobei beispielsweise fehlgeschlagene Bustransfers wiederholt werden. Die Information ob ein Bustransfer fehlgeschlagen, ist wird am Ende eines Bustransfers übertragen, quasi als Quittung für den Bustransfer. Um einen Bustransfer zu wiederholen ist es nunmehr erforderlich, dass sämtliche Adressen und bei Schreibzugriffen auch die wegzuschreibenden Daten noch zur Verfügung stehen. Erfindungsgemäß wird im Hinblick hierauf vorgeschlagen, dazu die Adress-FIFOs. (bevorzugt die Adress-FIFOs der IO-FIFOs) derart zu modifizieren, dass der Lesezeiger vor jedem Bursttransfer gespeichert wird. Es ist somit ein FIFO-Lesezeigerpositionsspeichermittel, insbesondere ein Adreß-FIFO-Leserzeigerpositionsspeichermittel vorgesehen. Dieses kann einen integralen Teil des Adress-FIFOs bilden, in dem beispielsweise ein Flag vorgesehen wird, das anzeigt, daß eine im FIFO abgelegte Information eine Lesezeigerposition darstellt, oder es kann separat zum FIFO vorgesehen werden. Alternativ könnte auch vorgesehen werden, den im FIFO abgelegten Daten einen die Löschbarkeit anzeigenden Status zuzuordnen, der mitabgelegt ist und diesen Status auf "löschbar" zurückzusetzen, sofern die erfolgreiche Datenübertragung quittiert wurde. Sofern ein Fehler auftrat, wird der Lesezeiger wieder auf die zuvor gespeicherte Position gesetzt und der Bursttransfer wiederholt. Trat kein Fehler auf, wird der nächste Bursttransfer durchgeführt und der Lesezeiger entsprechend neu gespeichert. Um zu verhindern, dass der Schreibzeiger in einen aktuellen Bursttransfer gelangt und damit Werte überschrieben werden, die evtl. bei einer Wiederholung des Bursttransfers noch benötigt werden, wird der Vollzustand der FIFOs durch den Vergleich des gespeicherten Lesezeigers mit dem Schreibzeiger festgestellt.

IO-FIFOs und/oder die FIFOs zur Verwaltung von Bursttransfers können bevorzugt jeweils mit der von den Interface-Baugruppen bekannten Funktion der Adresszuordnung zu eingehenden Lesedaten erweitert sein. Dabei kann den eingehenden Lesedaten auch die IOID zugeordnet werden, die bevorzugt zusammen mit den Adressen in den FIFOs gespeichert wird. Durch die Zuordnung der IOID zu eingehenden Lesedaten ist die Zuordnung der Lesedaten zu den entsprechenden Interface-Baugruppen möglich, indem beispielsweise die Multiplexer entsprechend der IOID geschaltet werden.

Erfindungsgemäß ist es möglich, bestimmte Bussysteme zu verwenden und/oder Bussysteme auf unterschiedliche Weise auszugestalten. Dies wird nachfolgend erörtert. Ausgestaltungsabhängig können zwischen den einzelnen Einheiten, insbesondere den Interface-Baugruppen, den IO-FIFOs, den Protokollkonvertern unterschiedliche Bussysteme zum Einsatz kommen, wobei zwischen je zwei Einheiten ein anderes Bussystem implementiert sein kann. Unterschiedliche Ausgestaltungen sind implementierbar, wobei die Funktionen mehrere Ausgestaltungen innerhalb einer Ausgestaltung zusammengefaßt sein können. Einige Ausgestaltungsmöglichkeiten sind nachfolgend aufgeführt.
Die einfachste mögliche Ausgestaltung ist die direkte Verbindung von zwei Einheiten. In einer erweiterten Ausführung liegen Multiplexer zwischen den Einheiten, die unterschiedlich ausgestaltet sein können. Dies Ausführung wird besonders bei der Verwendung mehrere der jeweiligen Einheiten bevorzugt. Eine Multiplex-Funktion kann durch einen konfigurierbaren Bus entstehen, der von einer übergeordenten Konfigurationseinheit (CT) jeweils für einen Zeitraum für die Verbindung bestimmter Einheiten untereinander konfiguriert werden kann. In einer bevorzugen Ausführung sind die Verbindungen durch Selektoren, die beispielsweise einen Teil einer Adresse und/oder eine IOID dekodieren, definiert, indem diese die Multiplexer zur Verschaltung der Einheiten ansteuern. In einer besonders bevorzugten Ausführung sind die Selektoren derart ausgestaltet, dass mehrere Einheiten zugleich eine andere Einheit selektieren können, wobei in zeitlicher Reihenfolge jeweils eine der Einheiten, zur Selektion arbitriert wird. Ein beispielsweise geeignetes Bussystem ist in DE 199 26 538A beschrieben.

Für die Arbitrierung können zusätzliche Zustände verwendet werden. Beispielsweise können Datentransfers zwischen den Interface-Baugruppen und den IO-FIFOs folgendermassen optimiert werden:
Jeweils ein Block einer definierten Größe von zu transferierenden Daten wird innerhalb der FIFO-Stufen zusammengefaßt. Sobald ein Block voll/leer ist wird dem Arbiter ein Buszugriff signalisiert, um die Daten zu übertragen. Die Daten werden in einer Art Burst-Transfer übertragen, d.h. der gesamte Datenblock wird während einer Buszuteilungsphase durch den Arbiter übertragen. Mit anderen Worten, kann eine Buszuteilung bedingt durch FIFO-Zustände der angeschlossenen FIFOs erfolgen, wobei innerhalb eines FIFOs Datenblöcke zur Zustandsbestimmung verwendet werden können. Ist ein FIFO voll, kann er den Bus zur Entleerung arbitrieren; ist ein FIFO leer, kann er den Bus zur Füllung arbitrieren. Zusätzliche Zustände können vorgesehen sein, beispielsweise in Flush, der zur Entleerung nur teilweise voller FIFOs und/oder zur Füllung nur teilweise leerer FIFOs verwendet wird. Ein Flush kann beispielsweise bei einem Konfigurationswechsel (Rekonfiguration) verwendet werden.

In einer bevorzugten Ausgestaltung sind die Bussysteme um hohe Datentransfer- und Taktraten zu erreichen durch geeignete Registerstufen als Pipelines aufgebaut und können beispielsweise selbst als FIFO arbeiten.

In einer bevorzugten Ausgestaltung kann die Multiplexerstufe ebenfalls gepipelinet ausgestaltet sein.

Erfindungsgemäß ist es möglich, mehrere Module an eine IO anzuschließen und eine Kommunikation der Module untereinander vorzusehen. Hierzu sei Folgendes angemerkt:
Aus DE 198 07 872A1, DE 199 26 538A1, DE 100 28 397A1 sind Konfigurations-Module bekannt, die eine bestimmte Funktion beinhalten, die wiederverwertbar und/oder innerhalb des PA relokatierbar sind.
Mehrere dieser Konfigurations-Module können abhängig und/oder unabhängig voneinander zugleich in das PA konfiguriert werden.
Die Konfigurations-Module müssen auf eine limitierte und insbesondere typischerweise nur an bestimmten Stellen vorgesehene und daher nicht relokatierbare IO, derart verschaltet werden, daß die Konfigurations-Module die IO zugleich benutzen können und die Daten den korrekten Modulen zugeordnet werden. Weiterhin müssen zusammengehörende (abhängige) Konfigurations-Module derart miteinander zu verschaltet werden, daß eine freie Relokation der Konfigurations-Module untereinander im PA möglich ist.

Durch die gewöhnlichen Netzwerke (DE 44 16 881C2, DE19654595A1, WO 98/26356 A1 WO 98/35299 A2) ist ein derart flexibler Aufbau zumeist nicht möglich, da dieses Netzwerk üblicherweise mittels eines Routers explizit alloziiert und geroutet werden muß.

In DE 197 94 742A1 ist ein Verfahren beschrieben, um flexible Datenkanäle innerhalb einer PAE-Matrix entsprechend der auszuführenden Algorithmen, so aufzubauen, daß eine direkte Verbindung durch eine und entsprechend einer Datenübertragung entsteht und danach wieder abgebaut wird. Die übertragenden Daten können jeweils exakt einer Quelle und/oder einem ziel zugeordnet werden.

Zusätzlich und/oder alternativ zu DE 197 04 742A1 und der dort beschriebenen vorgehensweise und den dort beschriebenen Anordnungen sind nun erfindungsgemäß weitere Möglichkeiten gegeben und Verfahren (nachfolgend zusammengefaßt mit GlobalTrack bezeichnet) einsetzbar, die eine flexible Alloziierung und Vernetzung zur Laufzeit ermöglichen, z.B. serielle Busse, parallele Busse, Lichtleiter mit jeweils geeigneten Protokollen (z.B. Ethernet, Firewire, USB). Es soll ausdrücklich auf die Übertragung per Licht durch ein lichtleitendes Substrat insbesondere bei geeigneter Modulation zur Trennung der Kanäle hingewiesen werden. Eine weitere Besonderheit der Erfindung mit Bezug auf die Speicheradressierung, insbesondere die Möglichkeit des Paging und MMU sei nachfolgend diskutiert.

Die Datenkanäle eines odere mehrerer GlobalTrack können über Vermittlungs-Knoten mit einem gewöhnlichen Netzwerk beispielsweise nach DE 44 16 881C2, DE 196 54 595 A1, WO 98/26356 A1, WO 98/35 299 A2 verbunden werden. Die Vermittlungs-Knoten können je nach Implementierung unterschiedlich im PA angeordnet sein, beispielsweise jeder PAE, einer Gruppe und/oder Hierarchie von PAEs und/oder jeder n-ten PAE zugeordnet sein. In einer besonders bevorzugten Ausgestaltung weisen sämtliche PAEs, Interface-Baugruppen, etc. einen, dedizierten Abschluß auf einen GlobalTrack auf.

Ein Konfigurations-Modul wird derart gestaltet, daß es Zugriff auf einen oder mehrere dieser Vermittlungs-Knoten erhalt.
Mehrere Konfigurations-Module untereinander und/oder Konfigurations-Module und IOs lassen sich nunmehr über den GlobalTrack miteinander verbinden. Bei entsprechender Implementierung (z.B. DE 197 04 742 A1) lassen sich mehrere Verbindungen gleichzeitig aufbauen und benutzen. Die Verbindung zwischen Sendern und Empfängern kann adressiert erfolgen, sodass ein individueller Datentranfer ermöglicht wird. Mit anderen Worten sind Sender und Empfänger über den GlobalTrack identifizierbar. Damit lassen sich übertragene Daten eindeutig zuordnen.

Mittels einer erweiterten 10, die die Sender und Empfängeradresse mit überträgt - wie beispielsweise aus DE 101 10 530A1 bekannt - und der Multiplexing-Verfahren nach DE 196 54 595A1, können Daten für unterschiedliche Module über die IO übertragen werden und sind ebenfalls eindeutig zuzuordnen.

Der Datentransfer wird in einer bevorzugten Ausgestaltung synchronisiert beispielsweise über Handshake-Signale. Weiterhin kann der Datentransfer gepipelinet also über mehrere im GlobalTrack implementierten oder diesem zugewiesenem Registern erfolgen. In einer sehr komplexen Ausführung für große VPU's bzw. deren Vernetzung untereinander, kann ein GlobalTrack in einer Netzwerktopologie mit Switches und Routers aufgebaut sein beispielsweise kann Ethernet eingesetzt werden.

Daß verschieden Medien für GlobalTrack Topologien verwendet werden können, z.B. das Verfahren nach DE 197 04 742A1 für VPU-interne Verbindungen und Ethernet für Verbindungen zwischen VPUs, sei erwähnt.

Speicher- (z.B. RAM-PAEs) können mit einem MMU ähnlichen Pageingverfähren ausgestattet sein. Beispielsweise kann dadurch ein großer externer Speicher in Segmente (Pages) zerlegt werden, die im Falle eines Datenzugriffs innerhalb eines Segmentes in einen der internen Speicher geladen und zu einem späteren Zeitpunkt nach Beendigung des Datenzugiffes wieder in den externen Speicher geschrieben werden. In einer bevorzugten Ausgestaltung werden an einen (internen) Speicher geleitete Adressen in einen Adressbereich, der innerhalb des internen Speichers (MEMADR) liegt (z.B. die unteren 10 bit bei einem 1024 Einträge Speicher), und eine Seitenadresse (die Bits oberhalb der unteren 10) zerlegt. Die Größe einer Seite/Page ist somit durch MEMADR bestimmt.

Die Seitenadresse wird mit einem dem internen Speicher zugeordneten Register (Seitenregister) verglichen. Das Register speichert den Wert der Seitenadresse, die zuletzt aus einem übergeordneten externen (Haupt-) Speicher in den internen Speicher transferiert wurde. Stimmt die Seitenadresse mit dem Seitenregister überein, kann ein wahlfreier zugriff auf den internen Speicher stattfinden. Sofern die Adresse nicht übereinstimmt (Pagefault) wird der aktuelle Seiteninhalt an die Stelle die durch das Seitenregister angegeben ist vorzugsweise linear in den externen (Haupt-)Speicher geschrieben. Der an der Stelle der aktuelle neuen Seitenadresse beginnende Speicherbereich im externen (Haupt-)Speicher (Seite/Page) wird in den internen Speicher geschrieben.

In einer besonders bevorzugten Ausführung kann durch Konfiguration vorgegeben werden, ob bei einem Pagefault die neue Seite aus dem externen (Haupt-) Speicher in den internen Speicher übertragen werden soll oder nicht. In besonderes bevorzugten Ausführung kann durch konfiguration vorgegeben werden, ob bei einem Pagefault die alte Seite von dem internen Speicher in den externen (Haupt-)Speicher übertragen werden soll oder nicht.

Der Vergleich der Seitenadresse mit dem Seitenregister erfolgt bevorzugt innerhalb des betreffenden Speichers. Die Datentransfersteuerung bei Pagefaults kann durch beliebige PAEs entsprechend konfiguriert werden und/oder durch DMAs (z.B. in den Interface-Baugruppen oder externe DMA) erfolgen. In eines besonders bevorzugten Ausführung sind die internen Speicher als aktive Speicher mit integrierter Datentransfersteuerung ausgelegt (vgl. DE 199 26 538 A1).

In einer weiteren möglichen Ausführung kann ein interner Speicher mehrere (p) Pages aufweisen, wobei die Größe einer Page dann bevorzugt der Speichergröße geteilt durch p beträgt. Eine übersetzungstabelle (translation Lookaside Buffer - TLB), die bevorzugt ähnlich eines voll assoziativen Caches ausgestaltet ist, ersetzt das Seitenregister und übersetzt Seitenadressen auf Adressen im internen Speicher, mit anderen Worten kann eine virtuelle auf eine physikalische Adresse übersetzt werden. Ist eine Page nicht in der Übersetzungstabelle (TLB) beinhaltet tritt ein PageFault auf. Weist die Übersetzungstabelle keinen Platz für neue zusätzliche Pages auf, können Pages aus dem internen Speicher in den externen (Haupt-)Speicher übertragen und aus der Übersetzungstabelle entfernt werden, sodass wieder Freiraum im internen Speicher zur Verfügung steht.

Es soll ausdrücklich darauf hingewiesen werden, dass sich eine detailliertere Ausführung erübrigt, da eine Vielzahl per se bekannter MMU-Verfahren nach dem Stand der Technik einsetzbar ist und mit geringfügigen und offensichtlichen Modifikationen einsetzbar ist.

Es wurde bereits vorstehend die Möglichkeit, erwähnt, einen sogenannten Collectorspeicher vorzusehen. Hierzu sei nunmehr noch detaillierter Folgendes ausgeführt:
Zwischen die Interface-Baugruppen und die 10-FIFOs kann ein Sammelspeicher (Collector) geschaltet werden, der größere Datenmengen speichern kann.
Der Collector kann zum Austausch von Daten zwischen den Interface-Baugruppen, bzw. zwischen Speichern die dem Array zugeordnet sind (z.B. RAM-PAEs) verwendet werden.
Der Collector kann als Puffer zwischen den Daten innerhalb eines rekonfigurierbaren Bausteins und externen Daten verwendet werden.
Ein Collector kann als Puffer von Daten zwischen unterschiedlichen Rekonfigurationsschritten dienen, beispielsweise kann er die Daten unterschiedlicher Konfigurationen speichern, während andere Konfigurationen gerade konfiguriert und aktiv sind. Bei der Deaktivierung von Konfigurationen speichert er deren Daten und die Daten der nunmehr neu konfigurierten und aktiven Konfigurationen werden, werden zum PA, z.B. in Speichern die dem Array zugeordnet sind (RAM-PAEs), übertragen.

Eine Mehrzahl von Interface-Baugruppen kann Zugriff auf den Collector haben und Daten in jeweils getrennten und/oder gemeinsam zugreifbaren Speicherbereichen, verwalten. In einer bevorzugen Ausgestaltung kann der Collector mehrere Anschlüsse für Interface-Baugruppen aufweisen, auf die zeitgleich zugegriffen werden kann (d.h. er wird als Multi-Port-Collectormittels ausgebildet). Der Collector besitzt einen oder mehrere Anschlüsse an einen externen Speicher und/oder die externe Peripherie. Diese können insbesondere mit den IO-FIFOs verbunden sein.

In einer erweiterten Ausgestaltung können der VPU zugeordneten Prozessoren wie DSPs, CPUs, Mikrokontroller auf den Collector zugreifen. Dies erfolgt bevorzugt über ein weiteres Multi-Port Interface. In einer bevorzugten Ausgestaltung ist dem Collector eine Adressübersetzungstabelle zugeordnet. Jedes Interface kann eine eigene Adressübersetzungstabelle oder alle Interface eine gemeinsame Adressubersetzungstabelle besitzen. Die Adressübersetzungstabelle kann von dem PA und/oder einer CT und/oder einer externen Einheit verwaltet werden. Die Adressübersetzungstabelle dient der Zuordnung von Collector Speicherbereichen zu beliebigen Adressen und arbeitet ähnlich einem MMU-System. Ist ein Adressbereich (Page) nicht innerhalb des Collector vorhanden (pagemiss), kann dieser Adressbereich aus einem externen Speicher in den Collector geladen werden. Weiterhin können Adressbereiche (Pages) aus dem Collector in den externen Speicher geschrieben werden. Zum Datentransfer zum bzw. zwischen dem externen Speicher wird bevorzugt eine DMA verwendet. Der DMA wird ein Speicherbereich innerhalb des Collector zur lesenden oder schreibenden Übertragung angegeben, die entsprechenden Adressen im externen Speicher können separat angegeben werden oder bevorzugt von der DMA aus der Adressübersetzungstabelle entnommen werden.

Ein Collector und dessen Adressgeneratoren (z.B. DMA) können bevorzugt entsprechend oder ähnlich per se bekannter MMU-Systeme für Prozessoren nach dem Stand der Technik arbeiten. Adressen können mit Übersetzungstabellen (TLB) für einen Zugriff auf den Collector übersetzt werden. Sämtliche für interne Speicher beschriebenen NMU-Ausgestaltungen und Verfahren können erfindungsgemäß auf einen Collector angewendet werden. Aus die Arbeitsweisen wird nicht näher eingegangen, da diese dem Stand der Technik entsprechen oder sehr ähnlich sind.

In einer erweiterten bzw. bevorzugten Ausgestaltung können mehrere Collectoren implementiert sein.

Es ist möglich, die Speicherzugriffe zu optimieren. Hierzu sei Folgendes angemerkt:
Eine Grundeigenschaft der bevorzugen rekonfigurierbaren VPU Architektur PACT-XPP ist die Möglichkeit Rekonfiguration und Datenverarbeitung zu überlagern (vgl. DE 44 16 881 C2, DE 196 51 075 A1, DE 196 54 846 A1, DE 196 54 593 A1, DE 198 07 872A1, DE 199 26 538 A1, DE 100 28 397 A1, DE 102 06 857 A1). Mit anderen Worten kann
   a) z.B. während einer Datenverarbeitung bereits die nächste Konfiguration vorgeladen werden und/oder
   b) z.B. während eine Anzahl von konfigurierbaren Elementen einer bestimmten Konfiguration noch nicht konfiguriert sind, bzw. gerade konfiguriert werden, die Datenverarbeitung in anderen bereits konfigurierten Elementen bereits beginnen- und/oder
   c) z.B. die Konfiguration verschiedener Aktivitäten derart entkoppelt oder überlagert werden, dass diese unter optimaler Performance gegeneinander zeitversetzt ablaufen (vgl. 8.1 Adressgenerierung)

Moderne Speicherprotokolle, (z.B. SDRAM, DDRAM, RAMBUS) weisen zumeist folgenden oder einen in der Wirkung ähnlichen Ablauf auf, wobei Schritt 2 und 3 evtl. auch umgekehrt auftreten:
1. Initialisiegung eines Zugriffes mit Adressangabe
2. Lange Latenzzeit
3. Schnelle Übertragung von Datenblöcken zumeist als Burst

Diese Eigenschaft kann in der VPU Technologie performanceeffizient ausgenutzt werden. Beilspielsweise ist es möglich, die Schritte der Berechnung der Adresse(n), der Initiallisierung des Speicher-Zugriffes, des Datentransfer und der Datenverarbeitung im Array (PA) jeweils derart zu trennen, dass verschiedene (zeitliche) Konfigurationen entstehen, wodurch eine weitgehend optimale Überlagerung der Speicherzyklen und der Datenverarbeitungszyklen erreicht werden kann. Mehrere der Schritte können je nach Anwendung auch zusammengefasst sein. Folgendes Verfahren entspricht beispielsweise diesem Prinzip: Es soll die Applikation AP ausgeführt werden, die aus einer Vielzahl von Konfigurationen (ap=1,2,...,z) besteht. Weiterhin werden auf der VPU weiter Applikationen/Konfigurationen ausgeführt, die unter WA zusammengefaßt sind
1. zunächst werden (in einer ap. Konfiguration von AP) die Lese-Adressen berechnet, die Datentransfers und die IO-FIFOs initialisiert,
2. die für AP übertragenen und inzwischen in den IO-FIFOs vorhanden Daten werden (in einer ap+1. Konfiguration) verarbeitet und ggf. in FIFOs / Puffer / Zwischenspeicher / etc. abgelegt,
2a. die Berechnung der Ergebnisse kann mehrere Konfigurationszyklen (n) erfordert, an deren Ende die Ergebnisse in einem IO-FIFO gespeichert sind
3. die Adressen der Ergebnisse werden berechnet und der Datentransfer initialisiert; dies kann parallel oder später in derselben oder einer ap+n+2. Konfiguration erfolgen, zugleich oder zeitlich versetzt werden dann die Daten aus den IO-FIFOS in die Speicher geschrieben.
Zwischen den Schritten können beliebige Konfiguration aus WA ausgeführt werden, z.B. wenn zwischen den Schritten eine Wartezeit notwendig ist, da Daten noch nicht zur Verfügung stehen.
Ebenfalls können während der Schritte parallel zu der Verarbeitung von AP Konfigurationen aus WA ausgeführt werden, z.B. wenn AP die für WA benötigten Ressourcen nicht verwendet.

Es ist dem Fachmann offensichtlich, dass unterschiedlich modifizierte Ausgestaltungen des Verfahrens möglich sind.

In einer möglichen Ausgestaltung kann das Verarbeitungsverfahren folgendermassen ablaufen (Z markiert einen Konfigurationszyklus, bzw. eine Zeiteinheit):

| | | |
|---|---|---|
| Z | Konfiguration AP | andere Konfigurationen (WA) |
| | | beliebige andere Konfigurationen und/oder Datenverarbeitungen, Schreib/lesevorgänge mit IC-FIFOs und/oder RAM-PAEs in anderen oder über Konfigurationszyklen zeitgemultiplexten Ressourgen |
| 1 | Leseadressen berechnen, Zugriff initialisieren | |
| 2 | Daten einlesen | |
| 3+k | Daten verarbeiten (ggf. in mehreren (k) Konfigurationszyklen) | |
| 4+k | Schreibadressen berechnen, Zugriff initialisieren | |
| 5+k | Daten ausschreiben | |
| | | |

Dieser Ablauf kann insbesondere von dem Datenverarbeitungsverfahren nach DE 102 02 044 A1 effizient genutzt werden.

Die vorstehenden Verfahren und Vorrichtungen werden bevorzugt betrieben unter Verwendung besonderer Compiler, die gegenüber herkömmlichen Compilern besonders erweitert sind. Hierzu sei Folgendes angemerkt:
Zur Generierung von Konfigurationen werden Compiler eingesetzt die auf einem beliebigen Rechnersystem ablaufen. Typische Compiler sind z.B. C-Compiler und/oder für die VPU Technologie z.B. auch NML-Compiler. Besonders geeignete Compilerverfahren sind in z.B. DE 101 39 170 A1, DE 101 29 237 A1, EP 02 001 331 A1 beschrieben.
Der Compiler soll bevorzugt folgende Besonderheiten zumindest partiell beachten:
Trennung der Adressierung in
   1. externe Adressierung, also die Datentransfers mit externen Baugruppen
   2. interne Adressierung,'also die Datentransfers zwischen, PAEs, i.b. zwischen RAM-PAEs und ALU-PAEs
   3. Desweiteren soll die zeitliche Entkopplung besondere Beachtung finden.

Bustransfers werden in interne und externe Transfers zerlegt.
bt1) Externe Lesezugriffe werden separiert, in einer möglichen Ausführung auch in eine separate Konfiguration übersetzt. Die Daten werde von einem externen Speicher in einen internen transferiert.
bt2) Interne Zugriffe werden mit der Datenverarbeitung gekoppelt, d.h. die internen Speicher werden für die Datenverarbeitung gelesen, bzw. beschrieben.
bt3) Externe Schreibzugriffe werden separiert, in einer möglichen Ausführung auch in eine separate Konfiguration übersetzt. Die Daten werden von einem internen Speicher in einen externen transferiert.

Wesentlich ist, dass die bt1, bt2, bt3 in unterscheidliche Konfigurationen übersetzt werden können und diese ggf. zu einem unterschiedlichen Zeitpunkt ausgeführt werden.

Das Verfahren soll an dem nachfolgenden Beispiel verdeutlicht werden:

```
 function example (a, b : integer) -> x : integer
 for i:= 1 to 100
   for j:= 1 to 100
      x[i] := a[i] * b[j]
```

Die Funktion wird vom Compiler in drei Teile, bzw. Konfigurationen (subconfig) transformiert:
example#dload: Läd die Daten von extern (Speicher, Peripherie, etc.) und schreibt diese in interne Speicher. Interne Speicher sind mit r# und dem Namen der ursprünglichen Variable gekennzeichnet.
example#process: Entsp'richt der eigentlichen Datenverarbeitung. Diese liest die Daten aus internem Operanden und schreibt die Ergebnisse wieder in interne Speicher. example#dstore; schreibt die Ergebnisse aus dem internen Speicher nach extern (Speicher, Peripherie, etc.).

```
 function Example# (a, b : integer) -> x : integer
 subconfig example#dload
 for i := 1 to 100
   r#a[i] := a[i]
 for j := 1 to 100
   r#b[j] := b[j]

 subconfig example#process
 for i := 1 to 100
   for j:= 1 to 100
     r#x[i] := r#a[i] * r#b[j]

 subconfig example#dstore
 for i := 1 to 100
   x[i] := r#x[i]
```

Ein wesentlicher Effekt des Verfahrens ist, dass anstatt i*j = 100 * 100 = 10.000 externe Zugriffe nur i+j = 100 + 100 = 200 externe Zugriffe zum Lesen der Operanden ausgeführt werden. Diese Zugriffe sind zudem noch vollkommen linear, was die Transfergeschwindigkeit bei modernen Bussystemen (Burst) und/oder Speichern (SDRAM, DDRAM, RAMBUS, etc) erheblich beschleunigt.
Die internen Speicherzugriffe erfolgen, parallel, da den Operanden unterschiedliche Speicher zugewiesen wurden.
Zum Schreiben der Ergebnisse sind i = 100 externe Zugriffe notwendig, die ebenfalls wieder linear mit maximaler Performance erfolgen können.

Wenn die Anzahl der Datentransfers vorab nicht bekannt ist (z.B. WHILE-Schleifen) oder sehr groß ist, kann ein Verfahren verwendet werden, das bei Bedarf durch Unterprogrammaufrufe die Operanden nachläd bzw. die Ergebnisse nach extern schreibt. Dazu können in einer bevorzugten Ausführung (auch) die Zustände der FIFOs abgefragt werden: 'empty' wenn das FI-FO leer ist, sowie 'full' wenn das FIFO voll ist. Entsprechend der Zustände reagiert der Programmfluß. Zu bemerken ist, dass bestimmte Variablen (z.B. ai, bi, xi) global definiert sind. Zu Performanceoptimierung kann ein Scheduler entsprechend der bereits beschriebenen Verfahren die Konfigurationen example#dloada, example#dloadb bereits vor dem Aufruf von example#process bereits ausführen, sodass bereits Daten vorgeladen sind. Ebenso kann example#dstore(n) nach der Terminierung von example#process noch aufgerufen werden um r#x zu leeren.

```
 subconfig example#dloada(n)
   while !full (r#a) AND ai<=n
     r#a[ai] := a[ai]
     ai++

 subconfig example#dloadb(n)
   while !full(r#b) AND bi<=n
     r#b[bi] := b[bi]
     bi++

 subconfig example#dstore(n)
   while !empty(r#x) AND xi<=n
     x[xi] := r#x[xi]
     xi++

 subconfig example#process
 for i := 1 to n
   for j := 1 to m
      if empty (r#a) then example#dloada (n)
      if empty(r#b) then example#dloadb(m)
      if full (r#x) then examplE#dstore (n)

     r#x[i] := r#a[i] * r#b[j]
   bj := 1
```

Die Unterprogrammaufrufe und das Verwalten der globalen variablen sind für rekonfigurierbare Architekturen vergleichsweise aufwendig. Daher kann in einer bevorzugten Ausführung die nachfolgende Optimierung durchgeführt werden, in welcher sämtliche Konfigurationen weitgehend unabängig ablaufen und nach vollständiger Abarbeitung terminieren (terminate). Da die Daten b[j] mehrfach erforderlich sind, muß example#dloadb entsprechend mehrfach durchlaufen werden. Dazu werden beispielsweise zwei Alternativen dargestellt: Alternative 1: example#dloadb terminiert nach jedem Durchlauf und wird von example#process für jeden Neustart neu konfiguriert.
Alternative 2: example#dloadb läuft unendlich und wird von example#process terminiert.

Während 'idle' ist eine Konfiguration untätig (wartend).

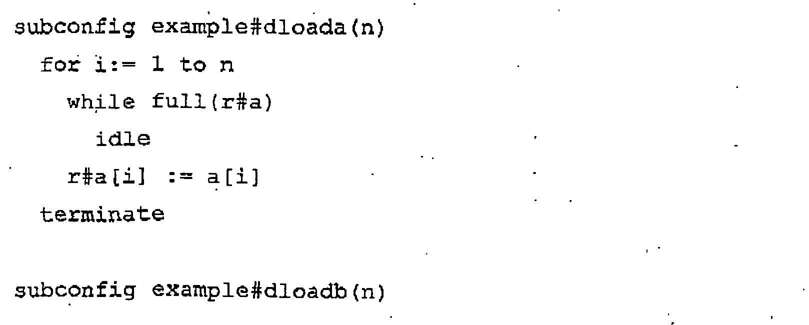

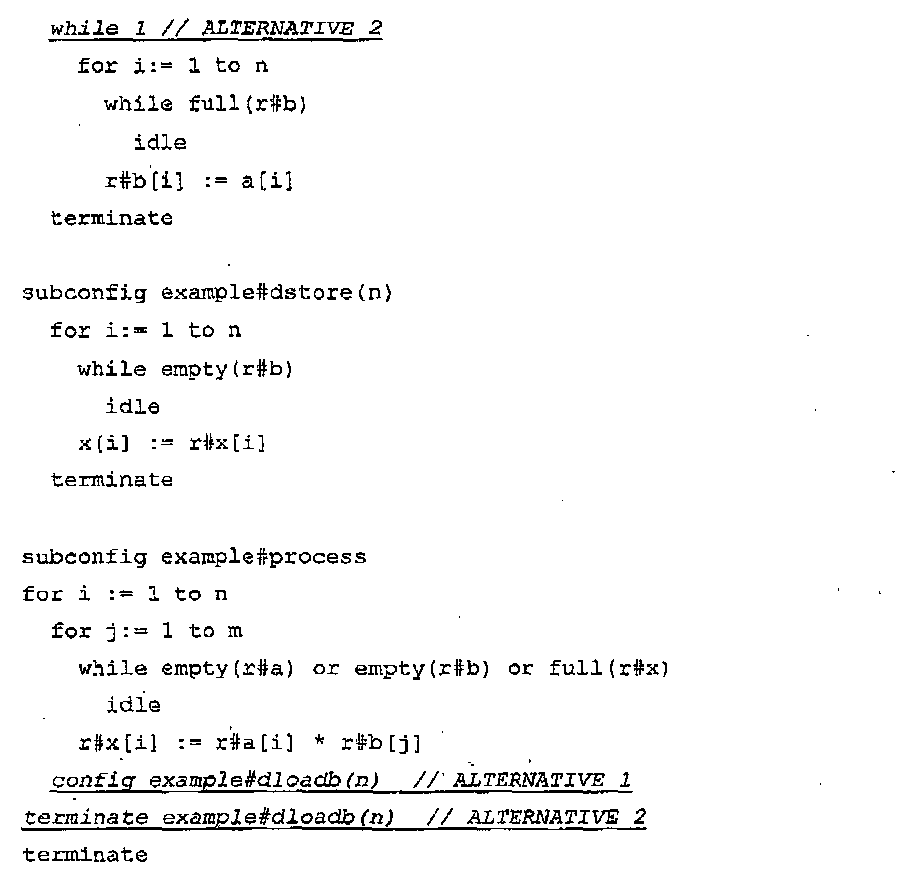

Zur Vermeidung von Wartezyklen können Konfigurationen auch terminiert werden, sobald sie ihre Aufgabe temporär nicht weiter erfüllen können. Die entsprechende Konfiguration wird von dem rekonfigurierbaren Baustein entfernt, verbleibt jedoch im Scheduler. Hierzu wird im Folgenden der Befehl 'reenter' verwendet. Die relevanten Variablen werden vor der Terminierung gesichert und bei der wiederholten Konfiguration wiederhergestellt:

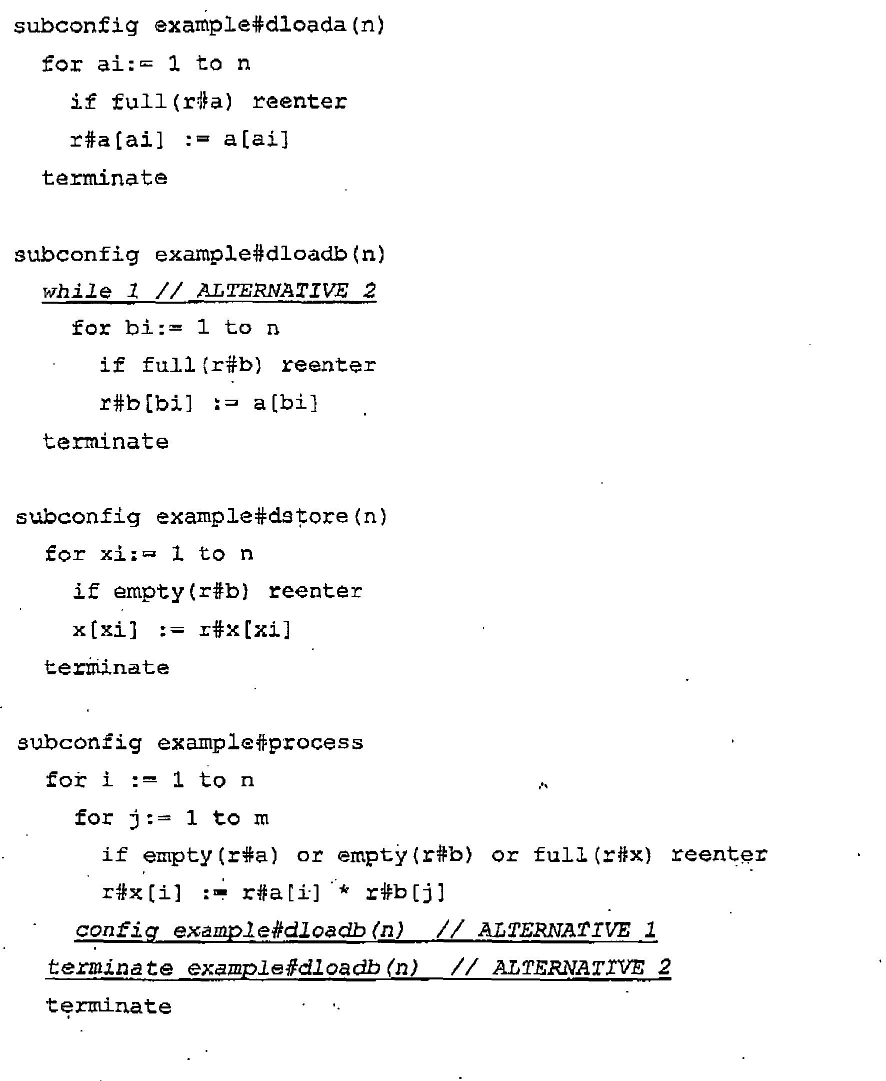

Zu dem vorstehenden und weiteren sei auf die Möglichkeit hingewiesen, einen sogenannten "Kontext-Switch" vorzusehen. Hierzu sei Folgendes angemerkt:
Der wiederholte Start von Konfigurationen, beispielsweise "reenter" erfordert das Sichern und Wiederherstellen von lokalen Daten (z.B. ai, bi, xi). Bekannte Verfahren nach dem Stand der Technik sehen explizite Interface zu Speichern oder zu einer CT vor, um die Daten zu transferieren. Sämtliche dieser Verfahren sind inkonsistent und/oder benötigen zusätzliche Hardware.
Der Kontext Switch wird derart durchgeführt, dass eine erste Konfiguration entfernt wird, die zu sichernden Daten verbleiben in den entsprechenden Speichern (REG) (Speicher, Register, Zähler, etc).
Eine zweite Konfiguration wird geladen, diese verbindet die REG in geeigneter Weise und definierter Reihenfolge mit einem oder mehreren globalen Speicher(n).
Die Konfiguration kann beispielsweise Adressgeneratoren verwenden, um auf den/die globalen Speicher zuzugreifen.
Die Konfiguration kann beispielsweise Adressgeneratoren verwenden um auf als Speicher ausgestaltete REG zuzugreifen. Entsprechend der konfigurierten Verbindung zwischen den REG werden die Inhalte der REG in einer definierten Reihenfolge in den globalen Speicher geschrieben, wobei die jeweiligen Adressen von Adressgeneratoren vorgegeben werden. Der Adressgenerator generiert die Adressen für den/die globale Speicher(n) derart, dass die beschriebenen Speicherbereiche (PUSHAREA) der entfernten ersten Konfiguration eindeutig zugeordnet werden können.
Mit anderen Worten, es sind bevorzugt für unterschiedliche Konfigurationen unterschiedliche Adressenräume vorgesehen. Die Konfiguration entspricht einem PUSH gewöhnlicher Prozessoren.

Danach verwenden andere Konfigurationen die Ressourcen.

Die erste Konfiguration soll wieder gestartet werden. Zuvor wird eine dritte Konfiguration gestartet, die die REG der ersten Konfiguration in einer definierten Reihenfolge miteinander verbindet.
Die Konfiguration kann beispielsweise Adressgeneratoren verwenden um auf den/die globalen Speicher zuzugreifen.
Die Konfiguration kann beispielsweise Adressgeneratoren verwenden um auf als Speicher ausgestaltete REG zuzugreifen.

Ein Adressgenerator generiert Adressen derart, dass ein korrekter Zugriff auf die der ersten Konfiguration zugeordnete PUSHAREA erfolgt. Die generierten Adressen und die konfigurierte Reihenfolge der REG sind derart, dass die Daten der REG in der ursprünglichen Ordnung aus den Speichern in die REG geschrieben werden. Die Konfiguration entspricht einem POP gewöhnlicher Prozessoren.
Die erste Konfiguration wird wieder gestartet.

Zusammengefaßt wird ein Kontext Switch derart durchgeführt, dass durch das Laden besonderer Konfigurationen, die ähnlich von PUSH/POP bekannter Prozessorarchitekturen arbeiten, die zu sichernden Daten mit einem globalen Speicher ausgetauschen werden.

Es besteht weiter die Möglichkeit, einen besonderen Task-Switch bzw. Multikonfigurationshandling vorzusehen.

In einer bevorzugten Arbeitsweise können unterschiedliche Datenblöcke unterschiedlicher Konfigurationen partitioniert werden. Auf diese Partitionen kann zeitoptimiert zugegriffen werden, indem beispielsweise während der Ausführung einer Konfiguration Q ein Teil der Operanden einer nachfolgenden Konfiguration P aus externen (Haupt-)Speichern und/oder sonstigen (peripheren) Datenströmen in die internen Speicher vorgeladen werden und während der Ausführung von P die Ergebnisse von Q als Teil des Gesamtergebnisses aus den internen Speichern an externe (Haupt-)Speicher und/oder sonstige (peripheren) Datenströme geschrieben werden.
Die Funktionsweise unterscheidet sich erheblich von der in US6,341,318 beschriebenen. Ein Datenstrom oder Datenblock wird bevorzugt durch eine FIFO-Struktur entkoppelt (z.B. IO-FIFO). Unterschiedliche Datenströme oder Datenblöcke insbesondere unterschiedlicher Konfigurationen werden bevorzugt durch unterschiedliche Speicher und/oder FIFO-Bereiche und/oder Zuordnungsmarkierungen in den FIFOs entkoppelt.

Die zuvor beschriebenen optionalen MMU-Verfahren können zum Entkoppeln und Puffern externer Daten verwendet werden.
In einer Anwendungsweise kann ein großer externen Datenblock in mehrere Segmente zerteilt werden, die jeweils innerhalb einer VPU verarbeitet werden können.
In einer zusätzlichen bevorzugten Arbeitsweise können unterschiedliche Datenblöcke unterschiedlicher Konfigurationen entsprechend des vorstehend erklärten Verfahrens in Partitionen zerteilt werden, die nunmehr als Pages für eine MMU definiert werden. Auf diese kann zeitoptimiert zugegriffen werden, indem beispielsweise während der Ausführung einer Konfiguration Q im PA die Operanden einer nachfolgenden Konfiguration P als Page aus externen (Haupt-)Speichern und/oder sonstigen (peripheren) Datenströmen in die internen Speicher vorgeladen werden und während der Ausführung von P die Ergebnisse von Q als Page aus den internen Speichern an externe (Haupt-)Speicher und/oder sonstige (peripheren) Datenströme geschrieben werden.

Für die vorstehenden Verfahren werden bevorzugt interne Speicher, die mehrere Partitionen bzw. Pages verwalten können eingesetzt.
Die Verfahren können für PAE-RAMs und/oder Collector-Speicher eingesetzt werden.
Bevorzugt werden Speicher mit mehrere Businterfaces verwendet (multi-port), um einen gleichzeitigen Zugriff von MMUs und/oder des PAs und/oder weiterer Adressgeneratoren/ Datentransfereinrichtungen zu ermöglichen.

In einer Ausgestaltung werden Kennungen bei den Datentransfers mitübertragen, die eine Zuordnung von Daten zu einer Resssource und/einer Applikation ermöglichen. Beispielsweise kann das in DE 101 10 530 A1 beschriebene Verfahren angewendet werden. Unterschiedliche Kennungen können auch gleichzeitig verwendet werden.
In einer besonders bevorzugten Ausführung wird eine Applikationskennungen (APID) bei jedem Datentransfer mit den Adressen und/oder Daten mitübertragen. Eine Applikation besteht aus mehreren Konfigurationen. Anhand der APID werden die übertragenen Daten einer Applikation bzw. den für eine Applikation bestimmte Speichern oder anderen Ressourcen (z.B. PAEs, Busse, etc) zugewiesen. Zu diesem Zweck können die APIDs unterschiedlich verwendet werden.
Beispielsweise können Interface-Baugruppen entsprechend von AIDS selektiert-werden.
Beispielsweise können Speicher entsprechend von APIDs selektiert werden.
Beispielsweise können PAEs entsprechend von APIDs selektiert werden.
Beispielsweise können Speichersegmente.in internen Speichern (z.B. PAE-RAMs, Coliector(en)) durch APIDs zugewiesen werden. Dazu können die APIDs ähnlich eines Adressteils in eine einem internen Speicher zugeordneten TLB eingetragen werden, womit ein bestimmter Speicherbereich (Page) abhängig von einer APID zugewiesen und selektiert wird.
Durch dieses Verfahren entsteht die Möglichkeit, Daten unterschiedlicher Applikationen innerhalb einer VPU effizient zu verwalten und auf diese zuzugreifen.
Optional besteht die Möglichkeit, explizit Daten bestimmter APIDs zu löschen (APID-DEL) und/oder an externe (Haupt-)Speicher und/oder sonstige (peripheren) Datenströme zu schreiben (APID-FLUSH). Dies kann jeweils erfolgen, wenn eine Applikation terminiert. APID-DEL und/oder APID-FLUSH können durch eine Konfiguration und/oder durch eine übergeordnete Ladeeinheit (CT) und/oder von extern ausgelöst werden.

Das folgende Verarbeitungsbeispiel soll das Verfahren verdeutlichen:
Eine Applikation Q (z.B. APID = Q) kann aus einer Konfiguration zum Lesen der Operanden (z.B. ConfigID = j), einer Konfiguration zum Verarbeiten der Operanden (z.B. ConfigID = w) und einer Konfiguration zum Schreiben den Ergebnisse (z.B. ConfigID = s) bestehen.
Die Konfiguration j wird zuerst ausgeführt, um zeitlich optimal entkoppelt die Operanden zu lesen. Gleichzeitig können Konfigurationen anderer Applikationen ausgeführt werden. Die Operanden werden entsprechend der Kennung APID aus externen (Haupt-)Speichern und/oder sonstigen (peripheren) Datenströmen in bestimmte interne Speicher und/oder Speicherbereiche geschrieben.
Die Konfiguration w wird ausgeführt, um die gespeicherten Operanden zu verarbeiten. Dazu wird unter Angabe von APID auf die entsprechenden Operanden in den internen Speichern und/oder Speicherbereiche zugegriffen, Ergebnisse werden entsprechend unter der Angabe von APID in interne Speicher und/oder Speicherbereiche geschrieben. Gleichzeitig können Konfigurationen anderer Applikationen ausgeführt werden. Abschließend schreibt die Konfiguration s die gespeicherten Ergebnisse aus den den internen Speichern und/oder Speicherbereiche an externe (Haupt-)Speichern und/oder sonstige (peripheren) Datenströme. Gleichzeitig können Konfigurationen anderer Applikationen ausgeführt werden.
Insoweit entspricht der Grundablauf des Verfahrens dem vorab beschriebenen zur Optimierung von Speicherzugriffen.

Sind Daten für eine bestimmte APID nicht in den Speichern vorhanden oder ist kein Speicherplatz für diese Daten mehr frei, kann ein Pagefault zur Übertragung der Daten ausgelöst werden.

Während vorstehend zunächst von einem Baustein ausgegangen wurde, bei dem ein Feld rekonfigurierbarer Elemente mit allenfalls geringe zusätzlicher Beschaltung wie Speichern, FIFOs und dergleichen vorgesehen wird, ist es auch möglich, die erfindungsgemäßen Ideen zu verwenden für Systeme, die als "systems on a chip" (SoC) bezeichnet werden. Für SoCs sind die Begriffe "intern" und "extern" nicht vollständig in ihrer herkömmliche Terminologie anwendbar, etwa wenn beispielsweise eine VPU mit weiteren Baugruppen (z.B. Peripherie, andere Prozessoren und insbesondere speichern) auf einem einzigen Chip gekoppelt bzw. verkoppelt sind. Es kann dann folgende Begriffsdefinition gelten, wobei ersichtlich sein wird, daß diese nicht schutzbeschränkend aufzufassen ist, sondern nur beispielhaft angibt, wie sich die Ideen der vorliegende Erfindung unproblematisch auf Konstrukte lesen lassen, die herkömmlich eine andere Terminologie verwenden:
intern: Innerhalb einer VPU Architektur, bzw. zur VPU Architektur und IP gehörende Bereiche
extern: Außerhalb einer VPU Architektur, d.h. alle sonstigen Baugruppen z.B. Peripherie, anderen Prozessoren und i.b. Speicher) auf einem SoC und/oder außerhalb des Chips in dem sich die VPU Architektur befindet.

Es sei nun eine bevorzugte Ausgestaltung beschrieben:
In einer besonders bevorzugten Ausgestaltung werden datenverarbeitenden FAEs lokal im PA (z.B. ALUs, Logik, etc.) angeordnet und verknüpft. RAM-PAEs können lokal im PA eingebunden sein, sind allerdings in einer besonders bevorzugten Ausgestaltung von dem PA abgesetzt oder an dessen Rändern angebracht (vgl. DE 100 50 442 A1). Dies erfolgt, um die Homogenität des PA bei großen RAM-PAE Speichern, deren Flächenbedarf weit größer als der von ALU-PAEs ist, nicht zu stören und aufgrund eines für gewöhnlich stark unterschiedlichen Gatter/Transistor-Layouts (z.B. GDS2) von Speicherzellen. Sofern die RAM-PAEs dedizierte Anschlüsse an ein externes Bussystem (z.B. globale Bus) aufweisen, sind sie aus Layout-, Floorplan- und Herstellungs-Gründen bevorzugt an den Rändern eines PA angeordnet.
Typischerweise wird zur physikalischen Anbindung das konfigurierbare Bussystem des PA verwendet.

In einer erweiterten Ausgestaltung weisen PAEs und Interface-Baugruppen, sowie ggf. weitere konfigurierbare Baugruppen einen dedizierten Anschluß an einen dedizierten globalen Bus z.B. einen GlobalTrack auf.

Interface-Baugruppen und insbesondere Protokollkonverter werden bevorzugt vom PA abgesetzt und ausserhalb derer Anordnung plaziert. Dies erfolgt, um die Homogenität des PA nicht zu stören und aufgrund eines für gewöhnlich stark unterschiedlichen Gatter/Transistor-Layouts (z.B. GDS2) des Interface-Baugruppen/Protokollkonverter: Desweiteren sind die Anschlüsse an externe Einheiten aus Layout-, Floorplan- und Herstellungs-Gründen bevorzugt an den Rändern eines PA angeordnet. Die Anbindung der Interface-Baugruppen an das PA erfolgt bevorzugt über das konfigurierbare Bussystem der PA, an dessen äußeren Rändern die Interface-Baugruppen angebunden werden. Das Bussystem erlaubt konfigurierbar den Datenaustausch zwischen Interface-Baugruppen und beliebigen PAEs innerhalb des PA; mit anderen Worten innerhalb einer oder unterschiedlicher Konfigurationen können Interface-Baugruppen z.B. mit RAM-PAEs verbunden sein, andere Interface-Baugruppen können beispielsweise mit ALU-PAEs verbunden sein.
Die IO-FIFOs werden bevorzugt in das Protokollkonverter integriert. Um eine höhere Flexibilität in der Zuordnung der internen Datenströme an die externen zu ermöglichen, sind die Interface-Baugruppen und Protokollkonverter getrennt ausgestaltet und mittels eines konfigurierbare Bussystems verbunden.

Die Erfindung wird im Folgenden nur beispielsweise in nicht limitierende Weise unter Bezugnahme auf die Zeichnung noch einmal erläutert.

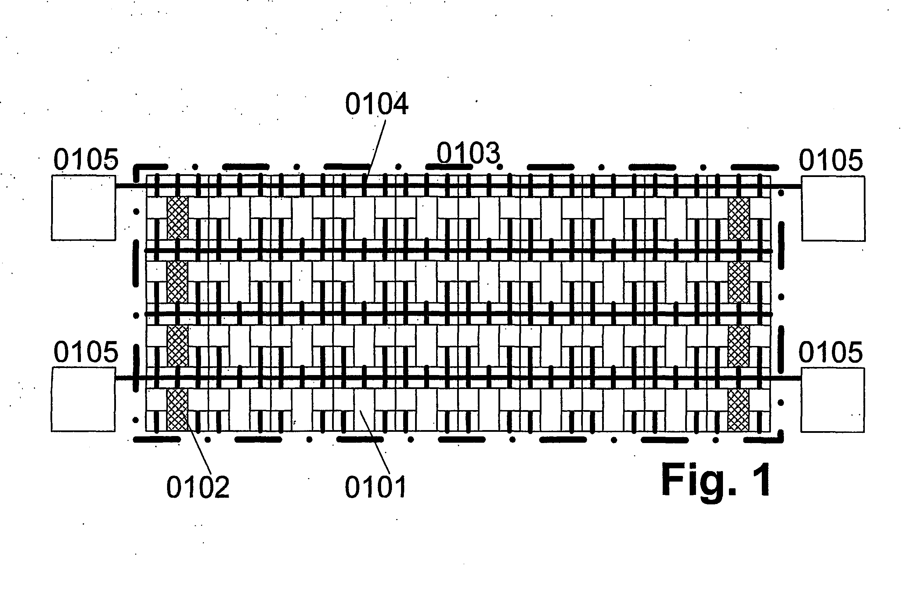

Figur 1 zeigt einen besonders bevorzugten Aufbau eines rekonfigurierbaren Prozessors, bestehend aus einem Kern (Array PA) (0103) beispielsweise bestehend aus einer Anordnung von ALU-PAEs (0101) (zur Durchführung von Berechnungen) und RAM-PAEs (0102) (zum Speichern) und entspricht damit dem Grundprinzip nach DE 196 54 846 A1. Wie bevorzugt befinden sich die RAM-PAEs nicht lokal im Kern integriert, sondern von den ALU-PAEs abgesetzt an den Rändern oder ausserhalb des Kerns. Dies erfolgt, um die Homogenität des PA bei großen RAM-PAE Speichern, deren Flächenbedarf weit größer als der von ALU-PAEs ist, nicht zu stören und aufgrund eines für gewöhnlich stark unterschiedlichen Gatter/Transistor-Layouts (z.B. GDS2) von Speicherzellen. Sofern die RAM-PAEs dedizierte Anschlüsse an ein externes Bussystem (z.B. dediziter globaler Bus; GlobalTrack; etc.) aufweisen, sind aus Layout-, Floorplan- und Herstellungs-Gründen bevorzugt an den Rändern eines PA angeordnet.
Die einzelnen Einheiten sind über Bussysteme (0104) miteinander verbunden. An den Rändern des Kernes befinden sich Interfacebaugruppen (Interface-Baugruppen und ggf. Protokollkonverter) (0105) ähnlich DE 196 54 595 A1 zu externen Bussen (IO). Die Interfacebaugruppen können implementierungsabhängig unterschiedlich ausgestaltet sein und beispielsweise eine oder mehrere der folgenden Funktionen erfüllen:
1. Zusammenführen und synchronisieren von mehreren Bussystemen, um beispielsweise Adressen und Daten zu synchronisieren
2. Adressgeneratoren und/oder DMAs
3. FIFO Stufen zur Entkopplung der Daten und/oder Adresse
4. Interfacecontrollern (z.B. für AMBA-Bus, RAMBUS, RapidIO, USB, DDRRAM, etc)

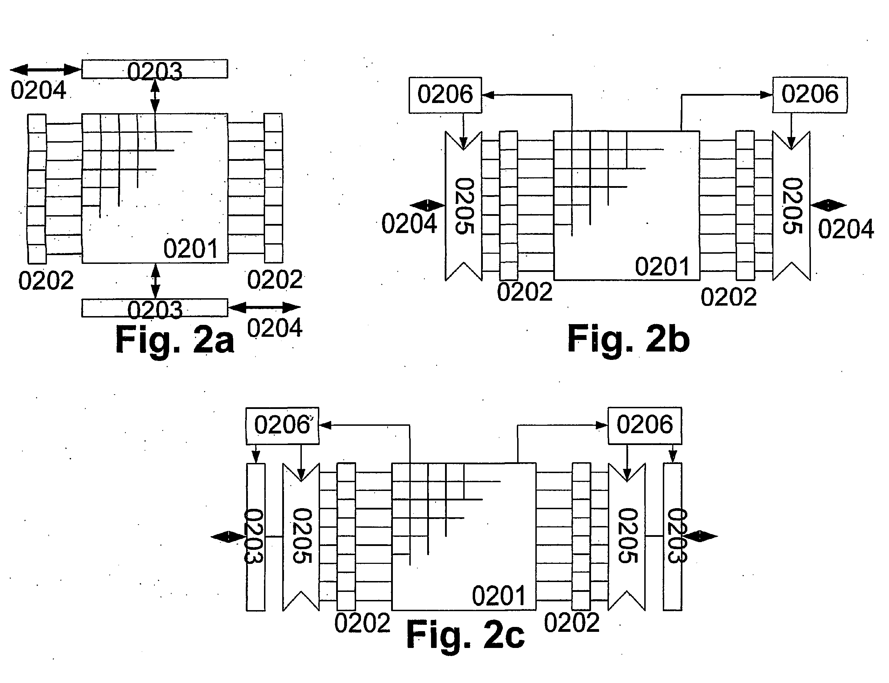

Figur 2 zeigt unterschiedliche Ausgestaltung der erfindungsgemäßen Architektur. 0201 stellt eine Anordnung von ALU-PAEs (PA) dar, die mit mehreren RAM-PAEs (0202) gekoppelt sind. Über FIFOs (0203) sind externe Busse (IO) (0204) angeschlossen.

Figur 2a zeigt eine direkte FIFO zu PA Kopplung.

In Figur 2b ist die IO (0204) über die RAM-PAEs (0202) mit 0201 verbunden. Die Verbindung erfolgt dabei typischeweise über das konfigurierbaren Bussystem 0104 oder ein dedizierte Bussystem. Multiplexer/Demultiplexer (0205) schalten eine Vielzahl von Bussen (0104) auf die IO (0204). Die Multiplexer werden durch eine Konfigurationslogik und/oder Adressselektierlogik und/oder einen Arbiter (0206) angesteuert. Die Ansteuerung der Multiplexer kann beispielsweise auch durch das PA erfolgen.

Figur 2c entspricht Figur 2b, jedoch sind vor die 10 noch FIFOs (0203) geschaltet.

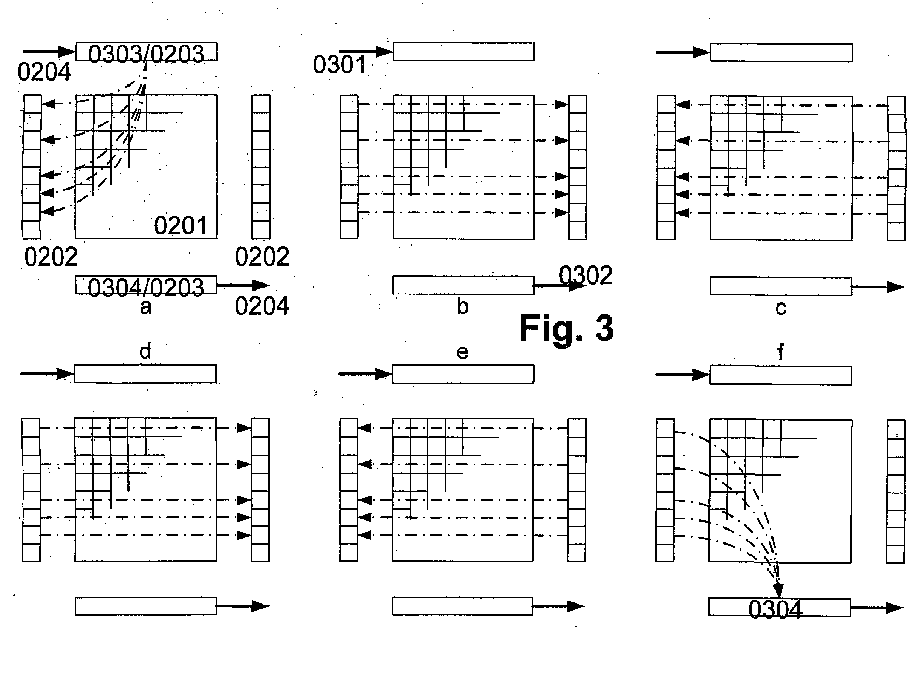

Die Darstellungen in den Figuren 3 entsprechen den Figuren 2, weshalb dieselben Referenzen verwendet sind. Figur 3 verdeutlich das bevorzugte Datenverarbeitungverfahren in einer VPU. Figur 3a: Daten gelangen über die 10 (0204) in einen Eingangs-FIFO (0303 entsprechend 0203) und werden von diesem in das PA (0201) und/oder zuvor in Speicher 0202 geladen.

Die Figuren 3b-e zeigen die Datenausführung, bei welcher Daten zwischen.den Speichern übertragen werden. Während dieser

Zeit können die FIFOs weiterhin Eingangsdaten (0301) und/oder. Ausgangsdaten (0302) übertragen.

In Figur 3f werden Daten aus dem PA und/oder aus den Speichern in in den Ausgangs-FIFO (0304) geladen.

Es soll nochmals darauf hingewiesen werden, dass das Einlesen von Daten aus dem Input-FIFO in die RAM-PAEs oder 0201 und das Schreiben von Daten aus 0201 oder den RAM-PAEs zeitgleich geschehen kann.
Ebenfalls soll darauf hingewiesen werden, dass die Input-/Output-FIFOs während der Schritte a-f kontinuierlich externe Daten empfangen bzw. senden können.

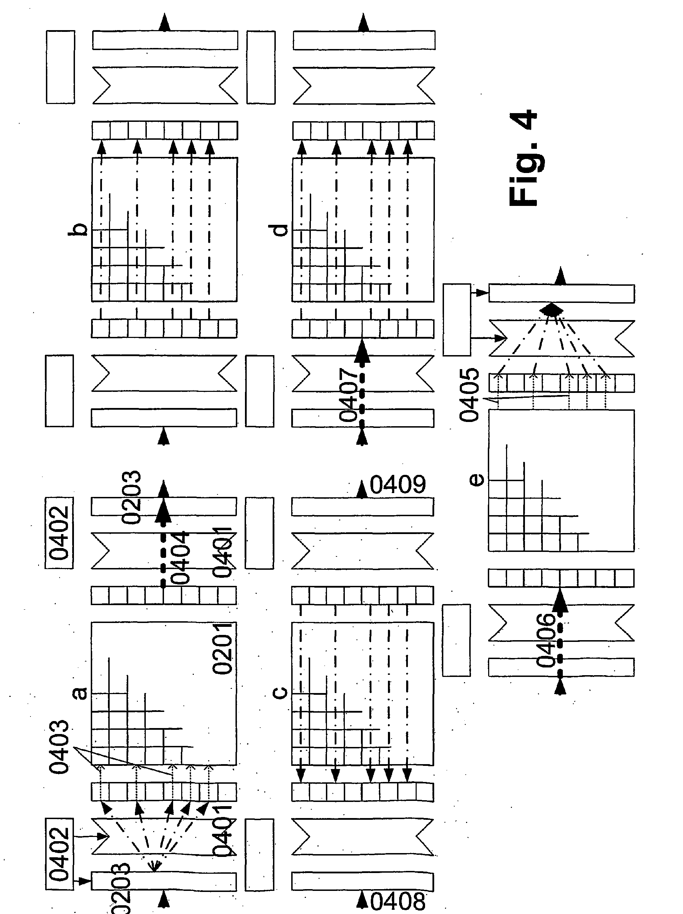

Figur 4 zeigt dasselbe Verfahren in einer leicht modifizierten Fassung, bei welcher Multiplexer/Demultiplexer (0401) zur einfachen Datenverteilung zwischen die FIFOs und 0201 geschaltet sind. Die Multiplexer werden durch eine Konfigurationslogik und/oder Adressselektierlogik und/oder einen Arbeiter (0402) angesteuert.
Mehrere Konfigurationen finden für die Datenverarbeitung' statt (a-e).
Die Daten können aus den FIFOs (Input-FIFOS) in Speicher und/oder direkt (0403) in das PA eingelesen werden. Nährend des Einlesevorganges können Daten aus dem PA und/oder Speichern in FIFOs (Output-FIFOs) geschrieben werden (0404). Zur Datenausgabe können Daten aus den Speichern und/oder direkt
(0405) aus dem PA an die FIFOs geschrieben werden. Währenddessen können neue Daten aus den Input-FIFOs an Speicher und/oder das PA geschrieben (0'406) werden.
Das Einschreiben neuer Daten (0407) kann beispielsweise bereits während einer letzten Konfiguration erfolgen.
Während der gesamten Verarbeitung können Daten von extern in die Input-FIFOs übertragen (0408), bzw. von den Output-FIFOs nach extern übertragen (0409) werden.

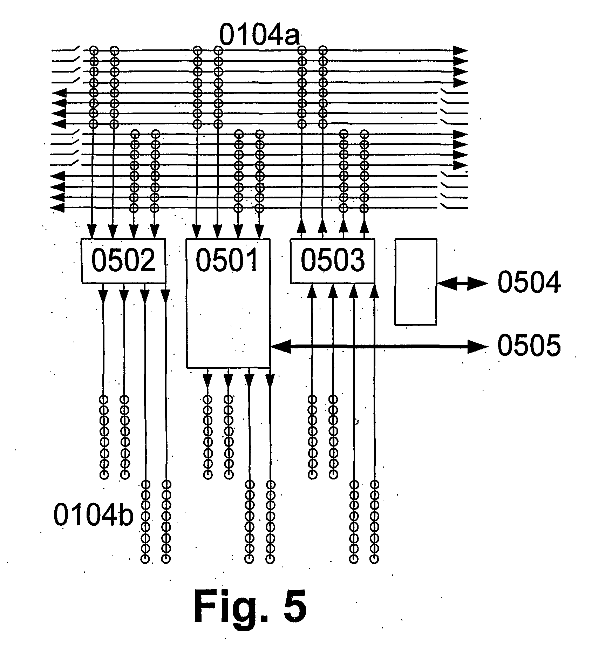

Figur 5 zeigt eine mögliche Ausgestaltung einer PAE. Ein erstes Bussystem (0104a) ist mit einer Datenverarbeitungeinheit (0501) verbunden deren Ergebnisse auf ein zweites Bussystem (0104b) übertragen werden. Der vertikale Datentransfer wird über zwei Register-/Multiplexerstufen (FREG 0502, BREG 0503) mit je unterschiedlicher übertragungsrichtung geführt. In die FREG/BREG können bevorzugt einfache ALUs beispielsweise für Addition, Subtraktion und Multiplexoperationen integriert sein. Über ein zusätzliches Interface (0504) wird die Einheit in ihrer Funktion und Vernetzung von einer Konfigurationseinheit (CT) konfiguriert, in einer bevorzugten Ausgestaltung besteht die Möglichkeit Konstanten in Register und/oder Speicher für die Datenverarbeitung zu setzen. In einer weiteren Ausgestaltung kann eine Konfigurationseinheit (CT) Daten aus den Arbeitsregistern und/oder Speichern auslesen. In einer erweiterten Ausgestaltung kann eine PAE zusätzlich einen Anschluß an einen dedizierten globalen Bus (0505) (z.B. einen GlobalTrack) aufweisen und damit beispielsweise direkt mit einem globalen ggf. auch externen Speicher und/oder Peripherie kommunizieren. Desweiteren kann ein globale Bus derart ausgestaltete sein, dass unterschiedliche PAEs direkt über diesen miteinander und in einer bevorzugten Ausführung auch mit Baugruppen für einen externen Anschluß (z.B. Interface-Baugruppen) kommunizieren können. Ein Bussystem wie beispielsweise in DE 197 04 742A1 beschrieben kann für derartige Zwecke eingesetzt werden.

Die Datenverarbeitungeinheit (0501) kann beispielsweise für ALU-PAEs als arithmetisch logische Einheit (ALU) ausgestaltet sein. Unterschiedliche ALU-PAEs können unterschiedliche AUS und Busaufschaltsysteme verwenden. Beispielsweise kann eine ALU mehr als 2 Busverbindungen zu 0104a und/oder 0104b aufweisen.

Die Datenverarbeitungeinheit (0501) kann beispielsweise für RAM-PAEs als Speicher ausgestaltet sein. Unterschiedliche RAM-PAEs können unterschiedliche Speicher und Busaufschaltsysteme verwenden. Beispielsweise kann ein Speicher mehrere i.b. mehr als 2 Busverbindungen zu 0104a und/oder 0104b aufweisen um beispielsweise den Zugriff mehrere Sender/Empfänger auf einen Speicher zuzulassen. Die Zugriffe können bevorzugt auch gleichzeitig erfolgen (Multi-Port).
Die Funktion des Speichers umfaßt beispielswiese folgende Funktionen oder Kombinationen daraus: Random Access, FIFO, Stack, Cache, Page Memory mit MMU-Verfahren.
Desweiteren kann in einer bevorzugten Ausführung der Speicher mit Daten von der CT vorgeladen werden (z.B. Konstanten, Lookup-Tabellen, etc). Ebenfalls kann die CT in einer erweiterten Ausführung Daten (z.B. zum Debuggen oder für Taskwechsel) aus dem Speicher über 0504 zurücklesen.
In einer weiteren Ausführung kann die RAM-PAE einen dedizierten Anschluß (0505) an einen globalen Bus aufweisen. Der globale Bus verbindet mehrere PAEs untereinander und in einer bevorzugten Ausführung auch mit Baugruppen für einen externen Anschluß (z'. B. Interface-Baugruppen). Für ein derartiges Bussystem kann das in DE 197 04 742 A1 beschriebene System verwendet werden.
RAM-PAEs können derart zusammengeschaltet werden, dass aus mehreren (n) RAM-PAEs ein n-fach größerer Speicher entsteht.

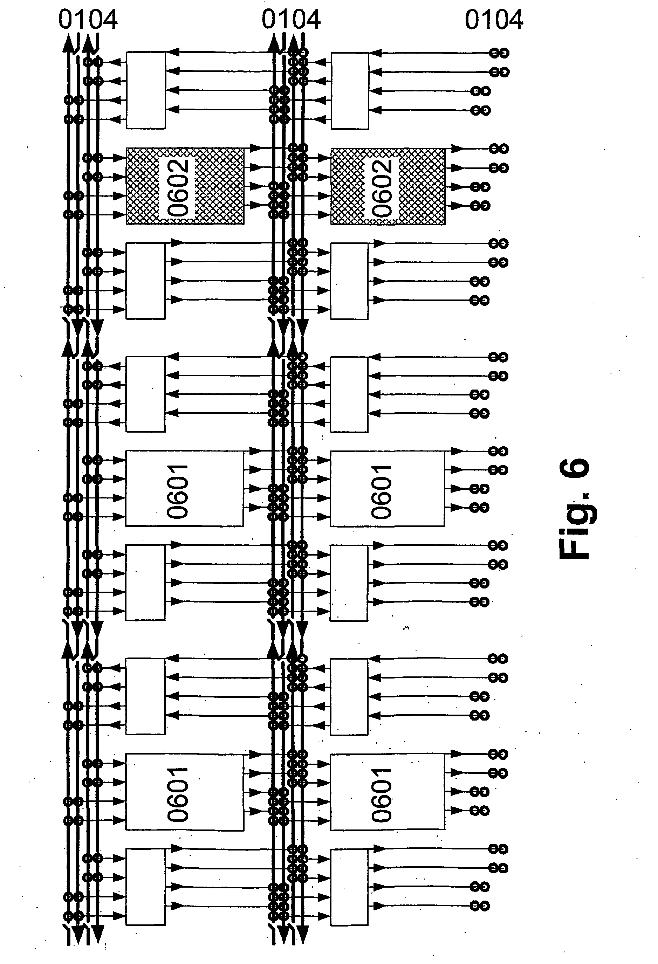

Figur 6 zeigt eine beispielhafte Verschaltung von ALU-PAEs (0601) und RAM-PAEs (0602) über Bussysteme 0104. Eine bevorzugte Verschaltung für einen rekonfigurierbaren Prozessor ist in Figur 1 dargestellt.

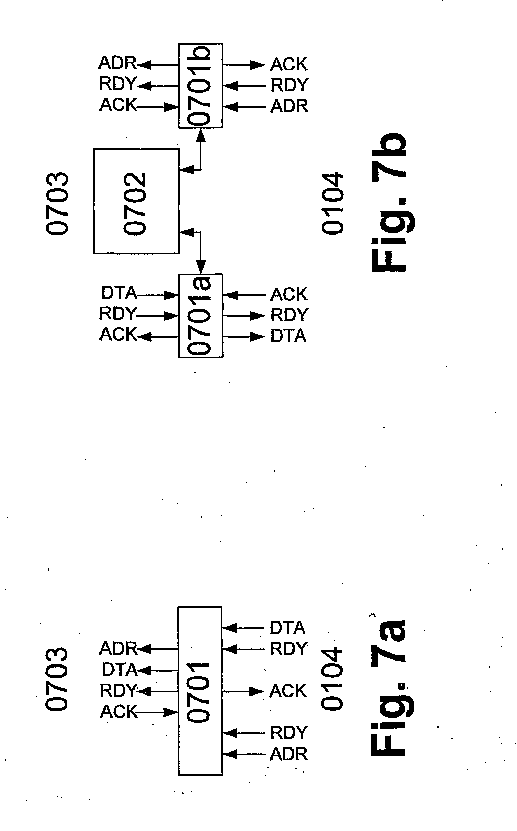

Figur 7 zeigt eine einfache Ausgestaltungsvariante einer IO-Schaltung entsprechend 0105. Es werden Adressen (ADR) und Daten (DTA) zusammen mit Synchronisationsleitungen (RDY/ACK) zwischen den internen Bussystemen (0104) und einem externen Bussystemen (0703) übertragen. Das externe Bussystem führt beispielsweise zu 10-FIFOs und/oder Protokollkonvertern.

Figur 7a zeigt eine Schaltung zum Schreiben von Daten, die von 0104 eingehenden Adressen und Daten werden miteinander verknüpft (0701). In der Interfaceschaltung (0701) kann eine FIFO-Stufe zur Entkopplung zwischen 0104 und 0703 vorgesehen sein.

Figur 7b zeigt eine Schaltung zum Lesen von Daten, bei welcher eine Quittierungschaltung (0702, z.B. FIFO, Zähler) für die Abstimmung der ausgehenden Adressen mit den eingehenden Daten vorgesehen ist. In 0701a und/oder in 0701b kann eine FIFO-Stufe zur Entkopplung zwischen 0104 und 0703 vorgesehen sein. Sofern in 0701b eine FIFO-Stufe vorgesehen ist, kann diese auch für die Quittierungschaltung 0702 mitverwendet werden.

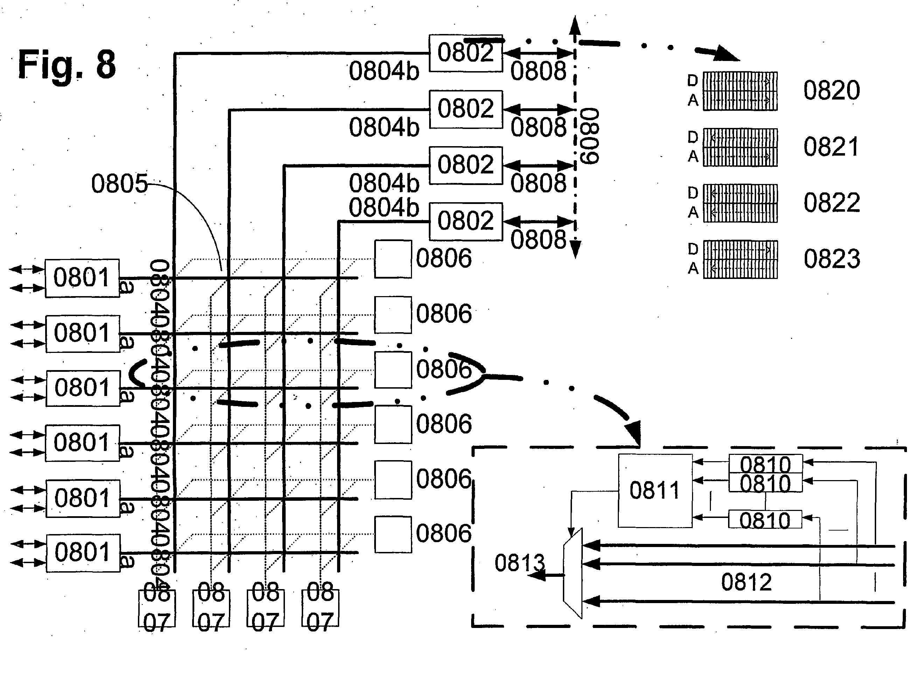

Figur 8 zeigt eine mögliche Verbindungsstruktur zwischen Interface-Baugruppen und/oder PAEs mit dediziertem globalen Bus (0801) und Protokollkänvertern (0802) zu externen (Haupt-)Speichern und/oder sonstigen (peripheren) Datenströmen. Die Interface-Baugruppen sind mit einem PA, vorzugsweise über deren Netzwerk entsprechend 0104 verbunden (0803).
Zwischen Interfäce-Baugruppen und/oder PAEs mit dediziertem globalen Bus (0801) und Protokollkonvertern (0802) ist ein Bussystem (0804a, 0804b) vorgesehen. 0804 kann in einer bevorzugten Ausgestaltung Daten über mehrere Registerstufen gepipelinet übertragen. 0804a und 0804b werden über Schalter (z.B. 0805), die beispielsweise als Transmission Gates und/oder Tristate-Buffer und/oder Multiplexer ausgestaltet sind, miteinander verschaltet. Die Multiplexer werden zeilen/spaltenweise angesteuert. Ansteuereinheiten (0806) steuern den Datentransfer der Interface-Baugruppen und/oder PAEs mit dediziertem globalen Bus (0801) an die Protokollkonverter (0802), also die Transferrichtung 0804a and 0804b. Ansteuereinheiten (0807) steuern den Datentransfer der Protokollkonverter (0802) auf die Interface-Baugruppen und/oder PAEs mit dediziertem globalen Bus (0801), also die Transferrichtung 0804b an 0804a. Die Ansteuereinheiten (0806) dekodieren jeweils Adressbereiche zur Selektion der Protokollkonvertern (0802), die Ansteuereinheiten (0807) dekodieren jeweils IOIDs zur Selektion der Intexface-Baugruppen und/oder PAEs mit dediziertem globalen Bus (0801).
Ansteuereinheiten können nach unterschiedlichen Ansteuerarten arbeiten, z.B. Feste Verbindung ohne Dekodierung; Dekodierung von Adressen und/oder IOIDs; Dekodierung von Adressen und/oder IOIDs und Arbitrierung. Ein oder mehrere Daten/Adressworte können pro Arbitrierung übertragen werden. Die Arbitrierung kann nach unterschiedlichen Regeln erfolgen. Die Interface-Baugruppen können bevorzugt einen kleinen FIFO für Adressen und/oder Daten in Ausgangs- und/oder Eingangsrichtung aufweisen. Eine besondere Arbitrierungsregel ärbitiert bevorzugt eine Interface-Baugruppe mit beispielsweise vollem (FULL) oder leerem (EMPTY) oder zu leerendem (FLUSH) FIFO.
Ansteuereinheiten können beispielsweise nach DE 199 26 538 A1 Fig. 32 aufgebaut sein. Diese Ansteuereinheiten können für 0807 oder 0806 verwendet werden. Bei Verwendung als 0806 enspricht 0812 0804a und 0813 entspricht 0804b. Bei Verwendung als 0807 enspricht 0812 0804b und 0813 entspricht 0804a. Dekoder (0810) dekodieren die Adressen/IOIDs der eingehenden Busse (0812) und steuern einen Arbiter (0811) an, der wiederum die eingehenden Busse über einen Multiplexer auf einen Ausgangsbus (0813) schaltet.
Die Protokollkonverter sind an externe Bussysteme (0808) gekoppelt, wobei mehrere Protokollkonverter auf demselben Bussystem (0809) aufgeschaltet sein können, wodurch sie dieselben externen Ressourcen nutzen können.
In den Protokollkonvertern sind bevorzugt die IO-FIFOs integriert, denen bei Bedarf ein FIFO (BURST-FIFO) für die Steuerung von Bursttransfers für die externen Busse (0808) nachgeschaltet ist. In einer bevorzugten Ausgestaltung ist den FIFOs eine weitere FIFO-Stufe (SYNC-FIFO) zur Synchronisation der ausgehenden Adressen mit den eingehenden Daten nachgeschaltet.
Verschiedene jeweils programmierbare/konfigurierbare FIFO-Strukturen sind in 0820-0823 dargestellt. A kennzeichnet die Laufrichtung eines Adress-FIFOs, D die Laufrichtung eines Daten-FIFOs. Die Datenübertragungsrichtung der FIFOs ist abhängig von der Datenübertragungsrichtung und Betriebsart. Arbeitet eine VPU als Busmaster, werden bei einem Schreibzugriff (0820) Daten und Adressen von intern auf den externen Bus übertragen, bei einem Lesezugriff. (0821) werden Adressen von intern nach extern und Daten von extern nach intern übertragen.

Arbeitet eine VPU als Busslave, werden bei einem Schreibzugriff (0822) Daten und Adressen von den externen Bus nach intern übertragen, bei einem Lesezugriff (0823) werden Adressen von extern nach intern und Daten von intern nach extern übertragen.
Bei sämtlichen Datentransfers können Adressen und/oder Daten IOIDs und/oder APIDs zugeordnet und in den FIFO-Stufen mit gespeichert werden.
In einer besonders bevorzugten Ausgestaltung kann durch die Entkopplung der Datentransfer durch die jeweiligen FIFO-Stufen, der Transferrate (Arbeitsfrequenz) der Bussysteme 0104, 0804 und 0808/0809 jeweils unterschiedlich sein. Insbesondere können die externen Bussysteme (0808/0809) beispielsweise mit einer'höheren Transferrate arbeiten als die internen Bussysteme (0104) und/oder (0804).

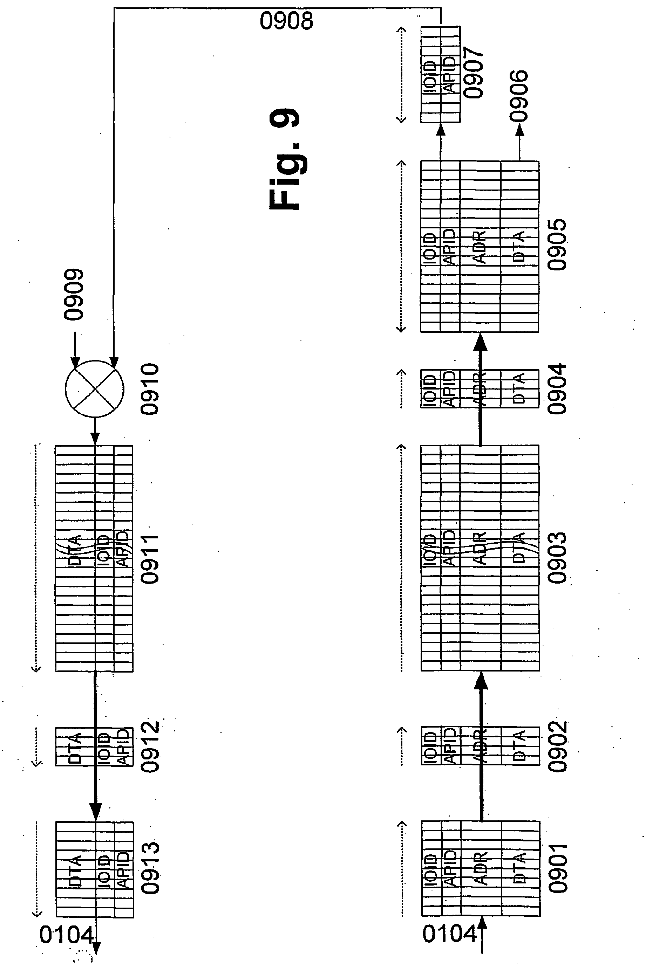

Figur 9 zeigt einen möglichen Ablauf eines Datenlesetransfers über die Schaltung nach Figur 8.
Adressen (vorzugsweise Kennungen wie z.B. mit IOIDs und/oder APIDs) werden über das interne Bussystem 0104 an Interface-Bäugruppen und/oder PAEs mit dedizierten globalen Bus übertragen, die vorzugsweise einen internen FIFOS (0901) aufweisen. Über ein Bussystem (z.B. 0804) das bevorzugt gepiplinet (0902) arbeitet, werden die Adressen in einen 10-FIFO (0903) übertragen. Über einen weiteren Bus (0904), der gepipelinet aufgebaut sein kann aber vorzugsweise kurz und lokal ist werden die Adressen in einen BURST-FIFO (0905) übertragen. Das BURST-FIFO dient der korrekten Abwicklung von Bursttransfers über das externe Bussystems, beispielsweise zur Steuerung von Burst-Adressen und -sequenzen und der Wiederholung von Burstzyklen bei aufgetretenen Fehlern- IOIDs und/oder APIDs von Adressen (0906) die über das externe Bussystem übertragen werden, können mit den Adressen, mitübertragen werden und/oder in einem zusätzlichen SYNC-FIFO (0907) gespeichert werden. Das SYNC-FIFO gleicht die Latenzzeit zwischen ausgehender Adresse (0906) und eingehenden Daten (0909) aus. Eingehenden Daten können IOIDs und/oder APIDs (0908) der sie referenzierenden Adressen über das SYNC-FIFO zugeordnet werden (0910). Die Daten (und vorzugsweise IOIDs und/oder APIDs) werden in einem 10-FIFO (0911) gepuffert und werden danach über ein Bussystem (z.B. 0804) das bevorzugt gepipelinet (0912) arbeitet an eine Interface-Baugruppe und/oder PAE mit dediziertem globalen Bus (0913) übertragen, die bevorzugt einen internen VIVO beinhaltet. Von dieser werden die Daten an das interne Bussystem (0104) weiterübertragen.
Optional können eingehende Daten anstatt in den 10-FIFO (0911) zunächst in einen nicht eingezeichneten zweiten BURST-FIFO geleitet werden, der sich entsprechend des BURST-FIFOs 0905 verhält, sofern ein Burst-Error-Recovery auch bei Lesezugriffen erforderlich ist. Danach werden die Daten an 0911 weitergeleitet.

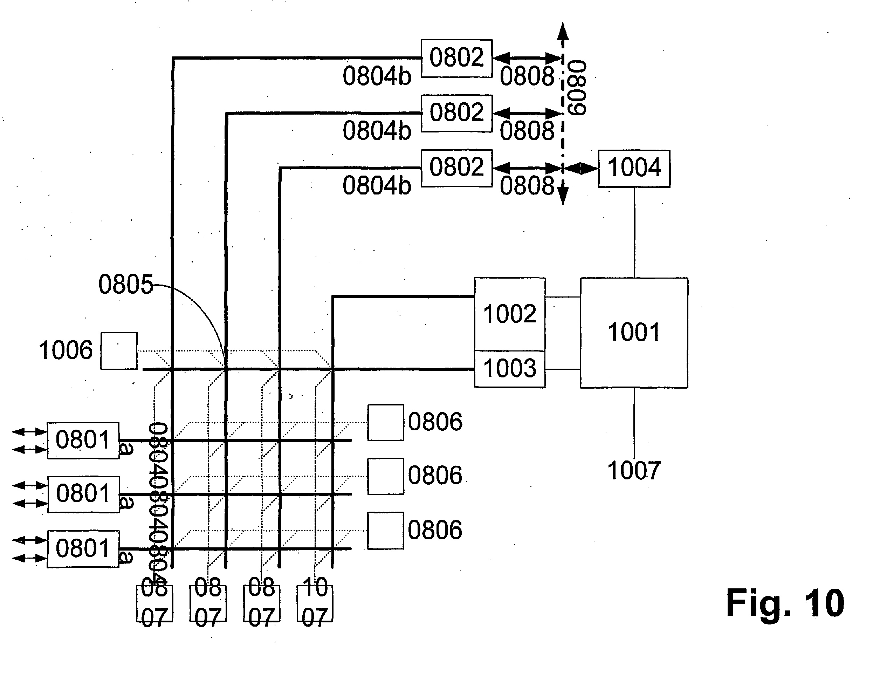

Figur 10 entspricht prinzipiell Figur 8, weshalb dieselben Referenzen verwendet wurden. Es wurden in dieser beispielhaften Ausgestaltung weniger Interface-Baugruppen und/oder PAEs mit dediziertem globalen Bus (0801) und weniger Protokollkonverter (0802) zu externen (Haupt-)Speichern und/oder sonstigen (peripheren) Datenströmen eingezeichnet. Zusätzlich wurde ein Collector (1001) eingezeichnet, der derart an die Bussysteme 0804 angeschlossen ist, dass Daten von den Interface-Baugruppen und den Protokollkonvertärn in den Collector geschrieben und/oder aus diesem gelesen werden können. Über die Ansteuereinheit 1007, die 0807 entspricht wird der Collector auf die 0804a Bussysteme aufgeschaltet, über die Ansteuereinheit 1006, die 0806 entspricht wird der Collector auf die 0804b Bussysteme aufgeschaltet.
Mehrere Collectoren können implementiert sein, wozu mehrere Ansteuereinheiten 1006 und 1007 verwendet werden.
Ein Collector kann in mehrere Speicherbereiche segmentiert sein. Jeder Speicherbereich für sich kann in unterschiedlichen Speichermodi arbeiten, beispielsweise als Random Access Speicher, FIFO, Stack, Cache, MMU Page etc.
Einem Collector kann eine übersetzungstabelle (TLB) (1002) zugeordnet sein, um eine MMU-artigen Betriebsart zu ermöglichen. Die Seiten (Page) verwaltung kann beispielsweise anhand von Segmentadressen und/oder sonstigen Kennungen wie beispielsweise APIDs und/oder IOIDs arbeiten.
Vorzugsweise ist einem Collector eine DMA oder mehrere DMAs zugeordnet, um Datentransfers mit externen (Haupt-)Speichern und/oder sonstigen (peripheren) Datenströmen durchzuführen, insbesondere um die MMU-Funktion der Pageverwaltung (laden, schreiben) von Pages automatisch zu ermöglichen. DMAs können zur Adressübersetzung zwischen externen (Haupt-)Speichern und/oder sonstigen (peripheren) Datenströmen und Collector ebenfalls auf die TLB zugreifen. DMAs können in einer möglichen Arbeitsweise Adressvorgaben aus dem Array (PA) erhalten, beispielsweise über 0804.
DMAs können durch eine oder mehrere der folgenden Einheiten angesteuert werden: Einer dem Collector zugeordneten MMU beispielsweise im Falle von Pagefaults; dem Array (PA); einem externen Bus (z.B. 0809); einem externen Prozessor; einer übergeordneten Ladeeinheit (CT).
Collectoren können Zugriff auf ein dediziertes und bevorzugte auch DMA-gesteuertes sowie bevorzugt Master/Slave fähiges Businterface (1004) mit Protokollkonverter entsprechend oder ähnlich den Protokollkonverterh 0802 zu externen

(Haupt-) Speichern und/oder sonstigen (peripheren) Datenströmen besitzen.

Ein externer Prozessor kann direkten Zugriff auf Collectoren haben (1007).

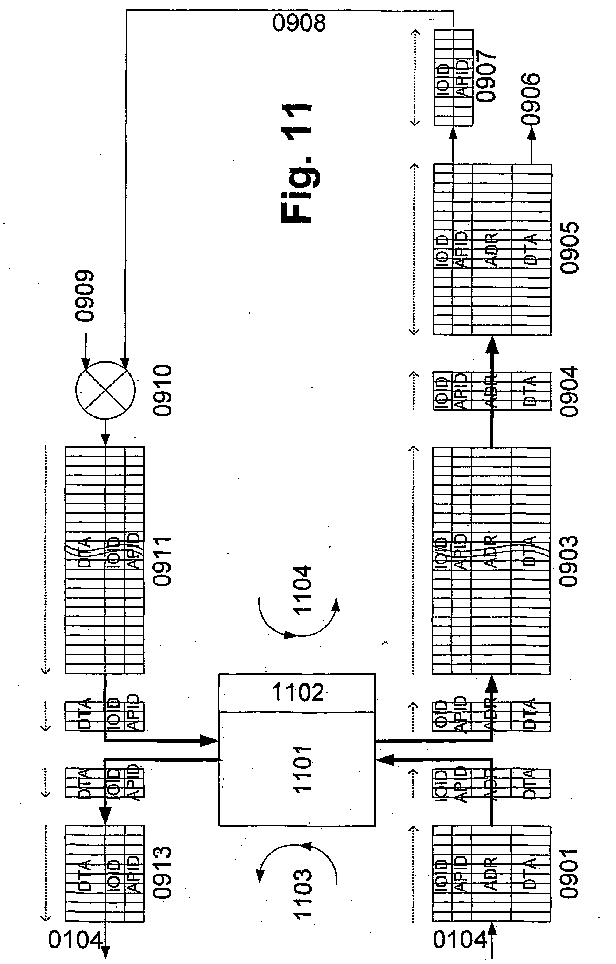

Figur 11 entspricht prinzipiell Figur 9, weshalb dieselben Referenzen verwendet wurden. In den Datenstrom integriert ist ein Collector (1101) mit zugeordneter Transfersteuerung (z.B. DMA bevorzugt mit TLB) (1102). Das Array (PA) transferiert Daten nunmehr bevorzugt mit dem Collector (1103). Dieser tauscht die Daten bevorzugt weitgehend selbständig über 1102 gesteuert mit externen (Haupt-)Speichern und/oder sonstigen (peripheren) Datenströmen aus (1104). Bevorzugt arbeitet der Collector in einer segmentierten MMU-ähnlichen Arbeitsweise, wobei unterschiedlichen Adressbereiche und/oder Kennungen wie APIDs und/oder IOIDs unterschiedliche Pages zugeordnet sind. Bevorzugt kann 1102 durch Pagefaults gesteuert werden.

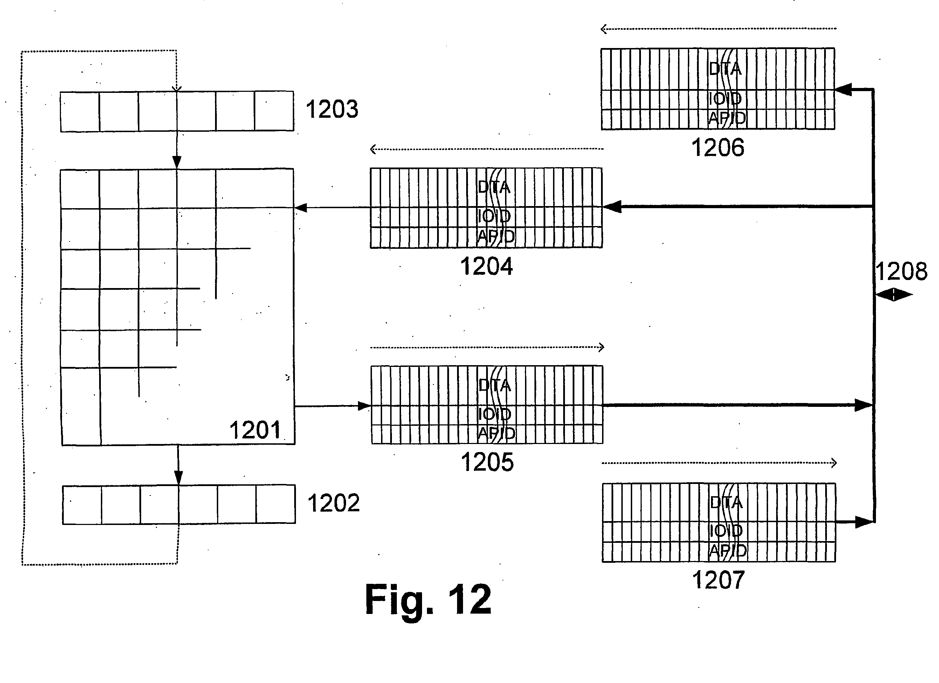

Figur 12 zeigt ein Ablaufschema von Datentransfers für unterschiedliche Applikationen. Ein Array (PA) verarbeitet Daten entsprechend dem in DE 196 54 846 A1 beschiebenen Verfahren durch Speicherung von Operanden und Ergebnissen in den Speichern 1202 und 1203. Dem PA sind zusätzlich ein Datetleingabekanal (1204) und ein Datenausgabekanal, (1205) zugeordnet, durch die Operanden und/oder Ergebnisse geladen bzw. gespeichert werden. Die Kanäle können zu externen (Haupt-)Speichern und/oder sonstigen (peripheren) Datenströmen.(1208) führen. Die Kanäle können aus internen FIFO-Stufen und/oder PAE-RAMs/PAE-RAM-Pages und/oder Collectoren/Collectorpages bestehen. Die Adressen (CURR-ADR) können aktuell durch eine in 1201 ablaufende Konfiguration berechnet werden und/oder vorberechnet sein und/oder durch DMA-Operationen eines (1003) berechnet sein. Insbesondere kann eine Adressberechnung innerhalb 1201 (CURR-ADR) an einen Collector oder dessen DMA geführt werden, um die Datentransfers des Collectors zu adressieren und zu steuern. Der Dateneingabekanal kann von einer vorhergehend auf 1201 ausgeführten Konfiguration bereits vorgeladen worden sein.
Die Kanäle arbeiten bevorzugt in einer FIFO-ähnlichen betriebsweise um Datentransfers mit 1208 durchzuführen.

In dem dargestellten Beispiel wird weiterhin ein Kanal (1207) während der beschriebenen Datenverarbeitung innerhalb 1201, der von einer vorherigen Konfiguration oder Applikation gefüllt wurde, an 1208 geschrieben. Dieser Kanal kann ebenfalls aus internen FIFO-Stufen und/oder PAE-RAMs/PAE-RAM-Pages und/oder Collectoren/Collectorpages bestehen. Die Adressen können aktuell durch eine parallel in 1201 ablaufende Konfiguration (OADR-CONF) berechnet werden und/oder vorberechnet sein und/oder durch DMA-Operationen eines (1003) berechnet sein. Insbesondere kann eine Adressberechnung innerhalb 1201 (OADR-CONF) an einen Collector oder dessen DMA geführt werden, um die Datentransfers des Collectors zu adressieren und zu steuern.

Weiterhin werden gleichzeitig Daten für eine nachfolgende Konfiguration oder Applikation in einen weiteren Kanal geladen (1206). Auch dieser Kanal kann aus internen FIFO-Stufen und/oder PAE-RAMs/PAE-PAM-Pages und/oder Collectoren/Collectorpages bestehen. Die Adressen können aktuell durch eine parallel in 1201 ablaufende Konfiguration (IADR-CONF) berechnet werden und/oder vorberechnet sein und/oder durch DMA-Operationen eines (1003) berechnet sein. Insbesondere kann eine Adressberechnung innerhalb 1201 (IADR-CONF) an einen Collector oder dessen DMA geführt werden, um die Datentransfers des Collectors zu adressieren und zu steuern. Einzelne Einträge in den jeweiligen Kanälen können unterschiedliche Kennungen, z.B. IOIDs und/oder APIDs aufweisen, um jeweils einer bestimmte Ressource und/oder Speicherstelle zugeordnet werden zu können.

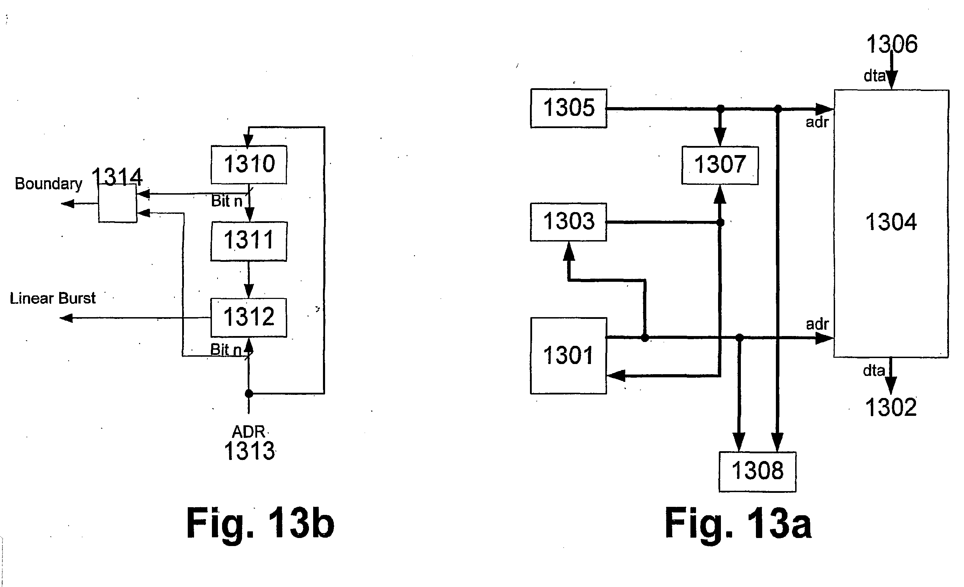

Figur 13a zeigt eine bevorzugte Implementierung eines BURST-FIFOs.
Zunächst soll die Funktion für einen Ausgabe-FIFO der seine Werte an einen burst-fähigen Bus (BBUS) überträgt beschrieben werden. Ein erster Zeiger (1301) zeigt auf den aktuell an den BBUS auszugebenden Dateneintrag innerhalb eines Speichers (1304). Mit jedem ausgegebenen Datenwort (1302) wird der 1301 um eine Position bewegt. Der Wert des Zeigers 1301 vor Beginn des aktuellen Bursttransfers wurde in einem Register (1303) gespeichert. Tritt ein Fehler während des Bursttransfers auf, wird 1301 mit dem ursprünglichen Wert aus 1303 neu geladen und der Bursttransfer wird neu gestartet.
Ein zweiter Zeiger (1305) zeigt auf die aktuelle Dateneinschreibposition im Speicher (1304) für einzuschreibende Daten (1306). Um ein Überschreiben eventuell bei einem Fehler noch benötigter Daten zu verhindern, wird der Zeiger 1305 mit dem Register 1303 verglichen (1307), um einen Vollzustand des BURST-FIFOs anzuzeigen. Der Leerzustand des BURST-ZIFOs kann durch Vergleich (1308) des Ausgabezeigers (1301.) mit dem Einschreibzeiger (1305) festgestellt werden. Arbeitet das BURST-FIFO für Einlesedaten von einem Bursttransfer, ändern sich die Punktionen wie folgt:
1301 wird zum Einschreibezeiger für die Daten 1306. Falls fehlerhafte Daten während des Bursttransfers übertragen wurden, wird die Position vor dem Bursttransfer in 1303 gespeichert. Tritt ein Fehler während des Bursttransfers auf, wird 1301 mit dem ursprünglichen Wert aus 1303 neu geladen und der Bursttransfer wird neu gestartet.
Der Zeiger zeigt auf die Ausleseposition des BURST-FIFOs zum Auslesen der Daten (1302). Um ein vorzeitiges Auslesen von Daten eines noch nicht korrekt abgeschlossenen Bursttransfers zu verhindern, wird 1305 mit der in 1303 gesicherten Position verglichen (1307), um einen leeren BURST-FIFO anzuzeigen. Ein voller BURST-FIFO wird durch den Vergleich (1308) des Einschreibzeigers 1301 mit dem Auslesezeiger (1305) erkannt.

Figur 13b zeigt eine mögliche Implementierung einer Burst-Schaltung, die mögliche Bursttransfers erkennt und Boundarygrenzen prüft. Die Implementierung ist einfach gehalten und erkennt lediglich lineare Adressfolgen. Datentransfers werden grundsätzlich als Bursttransfer gestartet. Bei der ersten nicht linearen Adresse wird der Bursttransfer abgebrochen. Durch eine Erweiterung einer Lookahead Logik, die mehrere Adressen im voraus prüft, lassen sich auch Bursttransfers einer bestimmten Länge (beispielsweise 4) feststellen und initialisieren.
Der Adresswert (1313) eines ersten Zugriffes wird in einem Register (1310) gespeichert. Der Adresswert eines darauffolgenden Datentransfers wird mit dem, um die Adressdifferenz zwischen ersten Datentransfers und dem zweiten Datentransfers des Bursttransfers (typischerweise eine Wortbreite) erhöhten Adresswert (1311) von 1310 verglichen (1312). Sind beide Werte gleich, so ist die Differenz der ersten Adresse und der zweiten Adresse entsprechend der Adressdifferenz des Bursttransfers zwischen zwei Burstadressen. Somit liegt ein korrekter Burst vor. Sind die Werte ungleich, muß der Bursttransfer abgebrochen werden.
Die jeweils letzte geprüfte Adresse (1313) (die zweite Adresse in der Beschreibung) wird jeweils in 1310 gespeichert und nachfolgend entsprechend mit der nächste Adresse (1313) verglichen.
Zur Feststellung der Einhaltung von Burstgrenzen (Boundaries) wird das Adressbit (oder die Adressbits), an denen die Boundary liegt des aktuellen Adresswertes (1313) mit dem Adresswert des vorhergehenden Adresswertes (1310) verglichen (z.B. XOR 1314). Sind die Adressbits ungleich wurde über die Boundary gesprungen und die Steuerung des Bursts hat entsprechend zu reagieren (z.B. Abschluß des Bursttransfers und neues Starten).

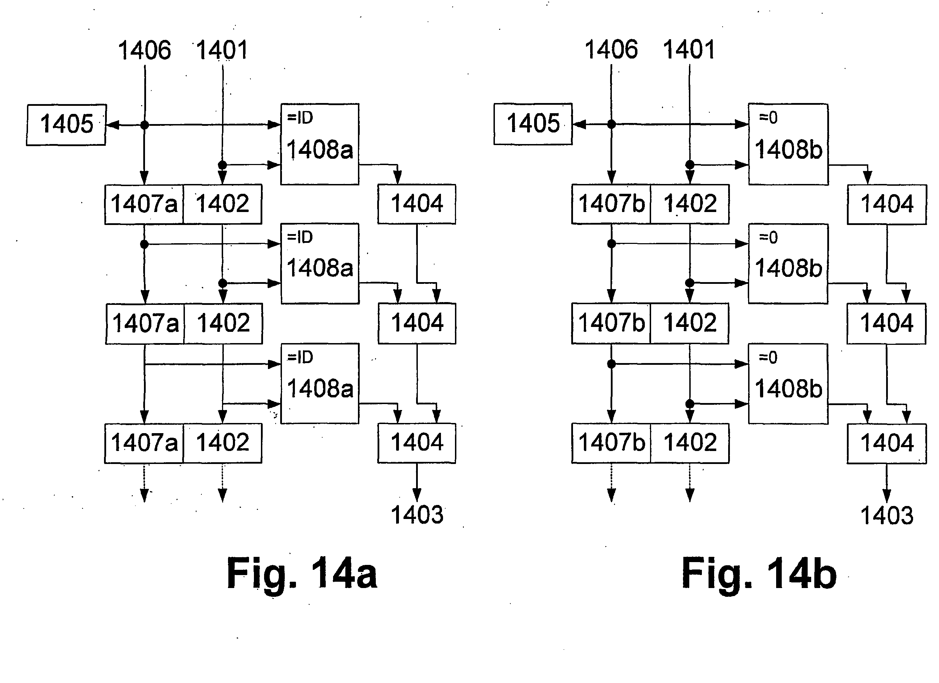

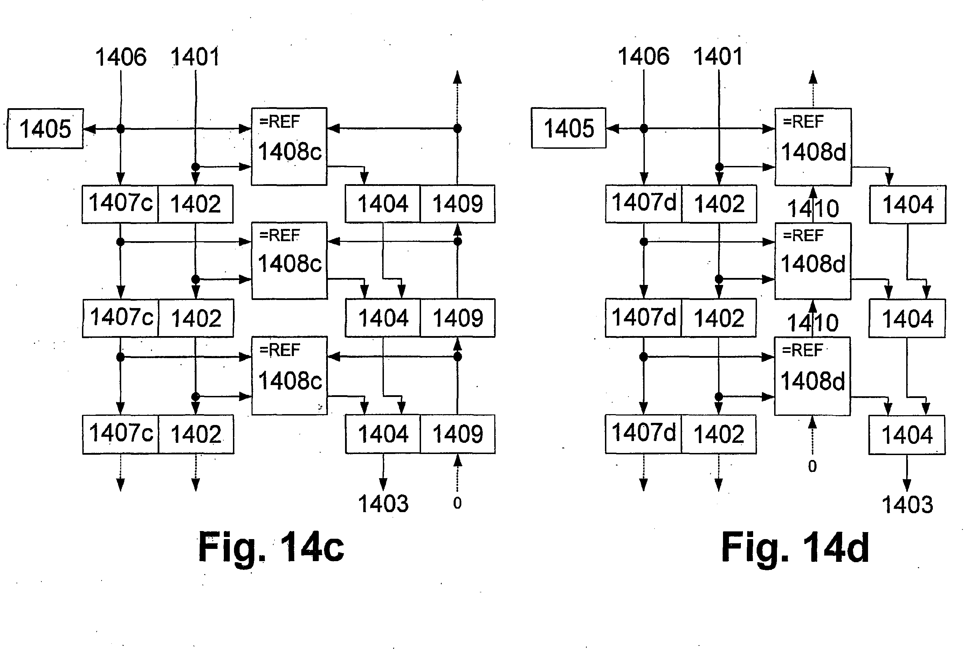

Figur 14 zeigt beispielhaft verschiedene Methoden, Speicher i.b. PAE-RAMs zu einem größerem zusammenhängenden Speicherblock zusammenzuschalten.
Die Figuren 14a-14d verwenden soweit möglich dieselben Referenzen.
Die Schreibdaten (1401) werden bevorzugt durch PipelineStufen (1402) an die Speicher geführt. Lesedaten (1403) werden bevorzugt ebenfalls über Pipelinestufen (1404) von den Speichern abgeführt. Die Pipelinestufe 1404 beinhaltet einen Multiplexer, der den jeweils aktiven Datenpfad weiterleitet. Der aktive Datenpfad kann beispielsweise durch das Anliegen eines RDY, Handshakes erkannt werden.
Eine Einheit (RangeCheck, 1405) zur Überwachung der Adressen (1406) auf korrekte Werte innerhalb des Adressraumes kann optional vorgesehen sein.
In Figur 14a werden die Adressen über Pipelinestufen (1407a) an die Speicher (1408a) geführt. Die Speicher vegleichen den höherwertigen Adressteil mit einer fest vorgegebenen oder konfigurierbaren (z.B. durch eine übergeordnete Konfigurationseinheit CT) Referenzadresse, die für jeden Speicher eindeutig ist. Bei Gleichheit wird der Speicher selektiert. Der niederwertige Adressteil dient der Auswahl der Speicherstelle im Speicher.
In Figur 14b werden die Adressen über Pipelinestufen mit integriertem Dekrementer (Subtraktion um 1) (1407b) an die Speicher (1408b) geführt- Die Speicher vegleichen den höherwertigen Adressteil mit dem Wert mull. Bei Gleichheit wird der Speicher selektiert. Der niederwertige Adressteil dient der Auswahl der Speicherstelle im Speicher.
In Figur 14c werden die Adressen über Pipelinestufen (1407c) an die Speicher (1408c) geführt. Die Speicher vegleichen den höherwertigen Adressteil mit Referenzadresse, die für jeden Speicher eindeutig ist. Die Referenzadresse wird durch eine Addierer- oder Subtrahiererkette (1409), die ausgehend von einem Startwert (typischerweise 0) für jeden Speicher eine andere eindeutige Referenzadresse vorgibt. Bei Gleichheit wird der Speicher selektiert. Der niederwertige Adressteil dient der Auswahl der Speicherstelle im Speicher.
In Figur 14d werden die Adressen über Pipelinestufen (1407d) an die Speicher (1408d) geführt. Die Speicher vegleichen den höherwertigen Adressteil mit Referenzadresse, die für jeden Speicher eindeutig ist. Die Referenzadresse wird durch eine in die Speicher integrierte Addierer- oder Subtrahiererkette
(1410), die ausgehend von einem Startwert (typischerweise 0) für jeden Speicher eine andere eindeutige Referenzadresse vorgibt. Bei Gleichheit wird der Speicher selektiert. Der niederwertige Adressteil dient der Auswahl der speicherstelle im Speicher.
Für 1402, 1404, 1407 kann beispielswiese FREGs der PAEs nach Figur 5 verwendet werden. Für 1409 können je nach Laufrichtung der Referenzadresse FREG oder BREG verwendet werden.

Der beschriebene beispielhafte Aufbau hat insbesondere den Vorteil, dass sämtliche Schreib-/Lesezugriffe dieselbe Latenzzeit aufweisen, da die Adressen und Daten über Registerstufen in den BREG/FREG geführt werden.

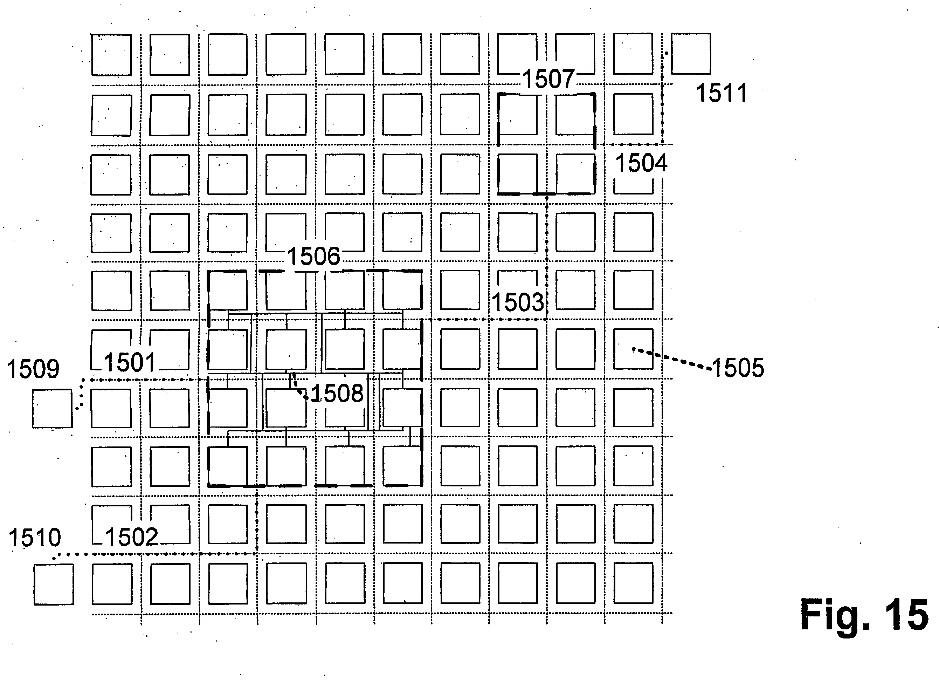

Figur 15 zeigt die Verwendung von GlobalTrack Bussystemen (1501, 1502, 1503, 1504) zur Kopplung von Konfigurationen die beliebige innerhalb einer Anordung von PAEs (1505) als Konfigurationsmakros (1506, 1507) (siehe auch DE 198 07 872 A1, DE 199 26 538 A, DE 100 28 397A1) konfiguriert wurden. Die Konfigurationsmakros weisen eigene interne Busverbindungen beispielsweise über interne Busse (0104) auf (1508). Die Konfigurationsmakros sind über 1503 miteinander zum Datenaustausch verbunden. Über 1501, 1502 besitzt 1506 Anschluß an Interface-Baugruppen und/oder lokale Speicher (PAE-RAMs) (1509, 1510). Über 1504 besitzt 1507 Anschluß an Interface-Baugruppen und/oder lokale Speicher (PAE-RAMs) (1511).

Beliebige weitere Ausgestaltungen und Kombinationen der erläuterten Erfindungen sind möglich und einem Fachmann offensichtlich.

## Patentansprüche

1. Vorrichtung zur Datenverarbeitung (0501) mit
einem Feld rekonfigurierbarer Elemente, aufweisend eine Schnittstellenanordnung zum Austausch eines Datenstromes zu verarbeitender Daten zwischen dem Feld rekonfigurierbarer Elemente und einer externen Schaltungsanordnung,
wobei ein Datenstromprotokoll für die Kommunikation mit der externen Schaltungsanordnung verschieden von einem Protokoll für bausteininterne Datenströme ist,
**dadurch gekennzeichnet, dass**
das Feld rekonfigurierbarer Elemente
arithmetisch-logische Einheiten (0601) aufweisende Elemente und
zur Realisierung einer Schnittstellenanordnung zum Austausch von Daten zwischen dem Feld rekonfigurierbarer Elemente und einer externen Schaltungsanordnung
an externe Busse (0703) gekoppelte Protokollconverter (802) mit FIFO-Speichern aufweist und ausgebildet ist
zur simultanen Abarbeitung wenigstens zweier voneinander unabhängiger Konfigurationen
derart, dass
eine Entkopplung
der Datenverarbeitung
unter Verwendung der arithmetischlogische Einheiten (0601) aufweisenden Felder durch eine erste Konfiguration
von einer Adressgenerierung
durch die zweite Konfiguration möglich ist
und Daten aus der externen Schaltungsanordnung von über mit der zweiten Konfiguration generierten Adressen in die FIFO-Speicher der Protokollconverter (802) mit FIFO-Speichern
vorladbar und
unter Protokollkonversion
einer späteren Konfiguration zur Datenverarbeitung
ausgebbar sind.

## Claims

1. Device for processing data (0501), with
an array of reconfigurable elements, having an interface arrangement for interchanging a data stream of data to be processed between the array of reconfigurable elements and an external circuit arrangement,
a data stream protocol for communicating with the external circuit arrangement being different from a protocol for module-internal data streams,
**characterized in that**
the array of reconfigurable elements
has elements having arithmetic logic units (0601), and,
in order to implement an interface arrangement for interchanging data between the array of reconfigurable elements and an external circuit arrangement,
has protocol converters (802) which are coupled to external buses (0703) and have FIFO memories,
and is designed
to simultaneously process at least two configurations which are independent of one another
in such a manner that it is possible to decouple
the data processing
using the arrays having arithmetic logic units (0601) by means of a first configuration
from address generation
by means of the second configuration,
and data from the external circuit arrangement can be preloaded into the FIFO memories of the protocol converters (802) having FIFO memories from addresses generated using the second configuration
and can be output
for data processing
with protocol conversion
of a subsequent configuration.

## Revendications

1. Dispositif de traitement de données (0501) comprenant un réseau d'éléments reconfigurables, présentant un système d'interface pour l'échange d'un flux de données à traiter entre le réseau d'éléments reconfigurables et un circuit externe,
dans lequel un protocole de flux de données destiné aux communications avec un circuit externe est différent d'un protocole destiné à des flux de données internes aux composants,
**caractérisé en ce que**
le réseau d'éléments reconfigurables présente des éléments comprenant des unités arithmétiques et logiques (0601), **en ce qu'**il comprend,
pour réaliser un système d'interface pour l'échange de données entre le réseau d'éléments reconfigurables et un circuit externe,
des convertisseurs de protocole (802) couplés à des bus externes (0703) et comprenant des mémoires FIFO,
et **en ce qu'**il est conçu pour
traiter simultanément au moins deux configurations indépendantes l'une de l'autre
de telle sorte qu'un découplage du traitement de données soit possible par utilisation du réseau d'éléments reconfigurables comportant des unités arithmétiques et logiques (0601) au moyen d'une première configuration d'une production d'adresse par l'intermédiaire de la seconde configuration et **en ce que**
des données provenant du circuit externe peuvent être pré-chargées à partir d'adresses générées à l'aide de la seconde configuration dans la mémoire FIFO des convertisseurs de protocole (802) comprenant des mémoires FIFO et
peuvent être délivrées par conversion de protocole d'une configuration ultérieure en vue du traitement des données.
